# EUROPEAN PATENT APPLICATION

(11) **EP 3 528 004 A1**
(43) Date of publication of application: **21.08.2019**
(21) Application number: 18156621.7
(22) Date of filing: 14.02.2018
(51) Int. Cl.: G01S 7/481, G01S 17/02, H01L 27/146

(54) **DETECTOR FOR AN OPTICAL DETECTION OF AT LEAST ONE OBJECT**

(71) Applicant: trinamiX GmbH, 67063 Ludwigshafen am Rhein (DE)
(72) Inventor: The designation of the inventor has not yet been filed
(74) Representative: Altmann Stößel Dick Patentanwälte PartG mbB

(57) **Abstract**

A detector (110) for an optical detection of at least one object (112) is proposed. The detector (110) comprises:
- at least one optical sensor (114), wherein the optical sensor (114) has at least one sensor region (130), wherein the optical sensor (114) is designed to generate at least one sensor signal in a manner dependent on an illumination of the sensor region (130), wherein the sensor signal, given the same total power of the illumination, is dependent on a geometry of the illumination, wherein the sensor region (130) has a photosensitive layer (134) comprising a layer (136) of a semiconducting material and having individual contacts to a first electrode (166) and to a second electrode (168), wherein the first electrode (166) is designed for collecting a first type of charge carriers and wherein the second electrode (168) is designed for collecting a second type of the charge carriers, wherein the first type of the charge carriers and the second type of the charge carriers are generated in the photosensitive layer (134) by the illumination, and wherein the first type of the charge carriers and the second type of the charge carriers are extractable from the photosensitive layer (134) with different extraction rates; and
- at least one evaluation device (150), wherein the evaluation device (150) is designed to generate at least one item of information on a longitudinal position of the object (112) by evaluating the sensor signal.

Thereby, a simple, cost-efficient and, still, reliable optical detector for determining a longitudinal position of at least one object is provided, which comprises a semiconducting material in the photosensitive layer (134).

## Description

### Field of the invention

The invention relates to a detector for an optical detection of at least one object, in particular, for determining a longitudinal position of at least one object, specifically with regard to a depth of the at least one object. Furthermore, the invention relates to a human-machine interface, an entertainment device, a scanning device, a tracking system, and a camera. Further, the invention relates to a method for optical detection of at least one object and to various uses of the detector.

### Prior art

Various detectors for optically detecting at least one object are known on the basis of optical detectors. WO 2012/110924 A1 discloses an optical detector comprising at least one optical sensor which exhibits at least one sensor region. Herein, the optical sensor is designed to generate at least one sensor signal in a manner dependent on an illumination of the sensor region. According to the so-called "FiP effect", the sensor signal, given the same total power of the illumination, is hereby dependent on a geometry of the illumination, in particular on a beam cross-section of the illumination on the sensor region. The detector furthermore has at least one evaluation device designated to generate at least one item of geometrical information from the sensor signal, in particular at least one item of geometrical information about the illumination and/or the object.

The optical sensors as exemplary disclosed in WO 2012/110924 A1 are selected from the group consisting of an organic solar cell, a dye solar cell, and a dye-sensitized solar cell (DSC), preferably a solid-state dye-sensitized solar cell (ssDSC). Herein, a DSC generally refers to a setup having at least two electrodes, wherein at least one of the electrodes is at least partially transparent, wherein at least one n-semiconducting metal oxide, at least one dye and at least one electrolyte or p-semiconducting material is embedded between the electrodes. In this kind of optical sensors, the sensor signal may be provided in form of an ac photocurrent which is enhanced when modulated light is focused onto the sensor area. However, as further indicated herein, in particular in Figures 5 and 6 of WO 2012/110924 A1, the sensor signal of silicon or germanium diodes, apart from marginal effects, which may be attributable to a boundary of the sensor region, and apart from noise effects, which are below 10%, does not exhibit the geometry dependence of the sensor signals on the illumination of the sensor region.

WO 2014/097181 A1 discloses a method and a detector for determining a position of at least one object, by using at least one transversal optical sensor and at least one longitudinal optical sensor. Preferably, a stack of longitudinal optical sensors is employed, in particular to determine a longitudinal position of the object with a high degree of accuracy and without ambiguity. In general, at least two individual "FiP sensors", i.e. a optical sensors based on the FiP-effect, are required in order to determine the longitudinal position of the object without ambiguity, wherein at least one of the FiP sensors is employed for normalizing the longitudinal sensor signal for taking into account possible variations of the illumination power. Further, WO 2014/097181 A1 discloses a human-machine interface, an entertainment device, a tracking system, and a camera, each comprising at least one such detector for determining a position of an object. Again, experimental results illustrated in Figure 5D of WO 2014/097181 A1 demonstrates that in an optical sensor based on silicon or germanium diodes, the sensor signal of the corresponding detector is independent from a cross-section of an light beam illuminating the sensor region.

Despite the advantages implied by the above-mentioned devices and detectors, there still is a need for improvements with respect to a simple, cost-efficient and, still, reliable spatial detector.

### Problem addressed by the invention

Therefore, a problem addressed by the present invention is that of specifying a device and a method for optically detecting at least one object which at least substantially avoid the disadvantages of known devices and methods of this type.

In particular, it would be desirous to provide a FiP sensor in which a semiconducting material, specifically crystalline silicon or germanium, but also other semiconducting materials, could, nevertheless, be used in a photosensitive layer, whereby the limitations described in WO 2012/110924 A1 and WO 2014/097181 A1 as indicated above may, thus, be overcome in order also to be capable of applying advantageous properties of crystalline silicon or germanium also in FiP devices.

### Summary of the invention

This problem is solved by the invention with the features of the independent patent claims. Advantageous developments of the invention, which can be realized individually or in combination, are presented in the dependent claims and/or in the following specification and detailed embodiments.

As used herein, the expressions "have", "comprise" and "contain" as well as grammatical variations thereof are used in a non-exclusive way. Thus, the expression "A has B" as well as the expression "A comprises B" or "A contains B" may both refer to the fact that, besides B, A contains one or more further components and/or constituents, and to the case in which, besides B, no other components, constituents or elements are present in A.

In a first aspect of the present invention, a detector for optical detection, in particular, for determining a position of at least one object is disclosed. The "object" may, generally, be an arbitrary object, chosen from a living object and a non-living object. Thus, as an example, the at least one object may comprise one or more articles and/or one or more parts of an article.

Additionally or alternatively, the object may be or may comprise one or more living beings and/or one or more parts thereof, such as one or more body parts of a human being, e.g. a user, and/or an animal.

As used herein, a "position" generally refers to an arbitrary item of information on a location and/or orientation of the object in space. For this purpose, as an example, one or more coordinate systems may be used, and the position of the object may be determined by using one, two, three or more coordinates. As an example, one or more Cartesian coordinate systems and/or other types of coordinate systems may be used. In one example, the coordinate system may be a coordinate system of the detector in which the detector has a predetermined position and/or orientation. As will be outlined in further detail below, the detector may have an optical axis, which may constitute a main direction of view of the detector. The optical axis may form an axis of the coordinate system, such as a z-axis. Further, one or more additional axes may be provided, preferably perpendicular to the z-axis.

Thus, as an example, the detector may constitute a coordinate system in which the optical axis forms the z-axis and in which, additionally, an x-axis and a y-axis may be provided which are perpendicular to the z-axis and which are perpendicular to each other. As an example, the detector and/or a part of the detector may rest at a specific point in this coordinate system, such as at the origin of this coordinate system. Alternatively, other types of coordinate systems may be used. Thus, as an example, a polar coordinate system may be used in which the optical axis forms a z-axis and in which a distance from the z-axis and a polar angle may be used as additional coordinates. In these coordinate systems, a direction parallel or antiparallel to the z-axis may be regarded as a "longitudinal direction", a coordinate along the z-axis may be considered as "a longitudinal coordinate", and a positon along the z-axis may be considered as "a longitudinal position" or "depth". An arbitrary direction perpendicular to the longitudinal direction may be considered a "transversal direction", an corresponding coordinate may be denoted as a "transversal coordinate", an a corresponding position may be denominated as a "transversal position" or "width".

As used herein, the detector for optical detection generally is a device which is adapted for providing at least one item of information on the position of the at least one object. The detector may be a stationary device or a mobile device. Further, the detector may be a stand-alone device or may form part of another device, such as a computer, a vehicle or any other device. Further, the detector may be a hand-held device. Other embodiments of the detector are feasible.

The detector may be adapted to provide the at least one item of information on the position of the at least one object in any feasible way. Thus, the information may e.g. be provided electronically, visually, acoustically or in any arbitrary combination thereof. The information may further be stored in a data storage of the detector or a separate device and/or may be provided via at least one interface, such as a wireless interface and/or a wire-bound interface. According to the first aspect of the present invention, the detector for an optical detection of at least one object, in particular for determining a position of at least one object, comprises:
- at least one optical sensor, wherein the optical sensor has at least one sensor region, wherein the optical sensor is designed to generate at least one sensor signal in a manner dependent on an illumination of the sensor region, wherein the sensor signal, given the same total power of the illumination, is dependent on a geometry of the illumination, in particular on a beam cross section of the illumination on the sensor region, wherein the sensor region has a photosensitive layer comprising a layer of a semiconducting material and having individual contacts to a first electrode and to a second electrode, wherein the first electrode is designed for collecting a first type of charge carriers and wherein the second electrode is designed for collecting a second type of the charge carriers, wherein the first type of the charge carriers and the second type of the charge carriers are generated in the photosensitive layer by the illumination, and wherein the first type of the charge carriers and the second type of the charge carriers are extractable from the photosensitive layer with different extraction rates; and
- at least one evaluation device, wherein the evaluation device is designed to generate at least one item of information on a longitudinal position of the object by evaluating the sensor signal.

Herein, the components listed above may be separate components. Alternatively, two or more of the components as listed above may be integrated into one component. Further, the at least one evaluation device may be formed as a separate evaluation device independent from the longitudinal optical sensor, but may preferably be connected to the longitudinal optical sensor in order to receive the longitudinal sensor signal. Alternatively, the at least one evaluation device may fully or partially be integrated into the longitudinal optical sensor.

As indicated above, the detector according to the present invention comprises at least one longitudinal optical sensor. Herein, the longitudinal optical sensor has at least one sensor region, i.e. an area within the longitudinal optical sensor which is sensitive to an illumination by an incident light beam. As used herein, the "longitudinal optical sensor" is, generally, a device which is designed to generate at least one longitudinal sensor signal in a manner dependent on an illumination of the sensor region by the light beam, wherein the longitudinal sensor signal, given the same total power of the illumination, is dependent, according to the so-called "FiP effect", on a geometry of the illumination, in particular on a beam cross-section of the light beam, in the sensor region. The longitudinal sensor signal may, thus, generally be an arbitrary signal indicative of the longitudinal position, which may also be denoted as the depth. As an example, the longitudinal sensor signal may be or may comprise a digital and/or an analog signal. As an example, the longitudinal sensor signal may be or may comprise a voltage signal and/or a current signal. Additionally or alternatively, the longitudinal sensor signal may be or may comprise digital data. The longitudinal sensor signal may comprise a single signal value and/or a series of signal values. The longitudinal sensor signal may further comprise an arbitrary signal which is derived by combining two or more individual signals, such as by averaging two or more signals and/or by forming a quotient of two or more signals.

Further according to the present invention, the longitudinal optical sensor comprises at least one photosensitive layer. As used herein, the term "photosensitive layer" relates to a material which is susceptible to an influence of the incident light beam. As generally used, the term "layer" refers to refers to an element having an elongated shape and a thickness, wherein an extension of the element in a lateral dimension exceeds the thickness of the element, such as by at least a factor of 10, preferably of 20, more preferably of 50 and most preferably of 100 or more. This definition may also be applicable to further kinds of layers as used herein, such as a collection layer, an extraction layer, a passivation layer, or a blocking layer. Herein, the layer which comprises a crystalline material may, preferably, be provided by generating, cutting and/or placing a single crystal or, preferably, a polycrystalline material on one of the other layers as a corresponding substrate. For other materials, in particular for a material which may not be applied in a single-crystalline form, a thin film thereof may be deposited on one of the other layers as the corresponding substrate. For a purpose of facilitating a production of a thin film, a deposition method may be used, preferably a coating method, more preferred one of a spin-coating method, a slot-coating method, a blade-coating method, or an evaporation method. By way of example, metal contacts may, thus, be provided in form of an evaporated contact or a sputtered contact or, alternatively, a printed contact or a coated contact, for which manufacturing a conductive ink may be employed. However, other methods may also be applicable.

According to the present invention, the at least one photosensitive layer of the optical sensor comprises a semiconducting material which may, preferably, be selected from at least one of crystalline silicon, crystalline germanium, a crystalline silicon-germanium alloy; amorphous silicon, copper indium selenide (CIS), copper indium gallium diselenide (CIGS), copper zinc tin sulfide (CZTS), copper zinc tin selenide (CZTSe); a II-VI semiconductor, specifically cadmium telluride (CdTe) or nanoparticulate lead sulfide (np-PbS); a III-V semiconductor, specifically indium phosphide (InP), gallium arsenide (GaAs), or indium gallium arsenide (InGaAs); an organic semiconductor, a blend of at least two organic semiconductors, a blend of at least one organic semiconductor with inorganic semiconductive particles; a solid solution, a doped variant or a mixture thereof. As generally used, the term "solid solution" refers to a state of the semiconducting material in which at least one solute is comprised in a solvent, whereby a homogeneous phase is formed and wherein a structure of the solvent, such as a crystalline structure, is, generally, unaltered by the presence of the solute. As further generally used, the term "doped variant" refers to introducing single atoms apart from the constituents of the material itself in the undoped state.

In a particularly preferred embodiment of the present invention, the semiconducting material may be a crystalline semiconducting material, wherein the crystalline semiconducting material may, preferably, be selected from at least one of crystalline silicon, also abbreviated to "c-Si", crystalline germanium, or a doped variant thereof. However, a silicon-germanium alloy which refers to a mixture of silicon and germanium having a molar ratio 0 < x < 1 that may be expressed by a molecular formula of Si₁₋ₓGeₓ, may also be applicable.

Upon illumination of the photosensitive layer by the incident light beam an amount of at least one type of charge carriers is generated within the photosensitive layer, wherein the amount of the generated charge carriers depends on the power and the geometry of the illumination of the photosensitive layer by the incident light beam. The charge carriers which are generated within the photosensitive layer are, subsequently, collected by at least one corresponding electrode designed to collect the respective type of the charge carriers, i.e. electrons or holes. Herein, a first electrode is designed for collecting a first type of charge carriers, e.g. the holes, and a second electrode is designed for collecting a second type of charge carriers, e.g. the electrons, or vice-versa. As generally used, the term "electrode" refers to an electrically highly-conductive material having an electrical conductance which may, specifically, be in a metallic or a highly-conducting semiconducting range, preferably of 10⁵ S/cm, preferably of 10⁶ S/cm, preferably of 107 S/cm, or above.

In particular for facilitating a collection of the generated charge carriers, the photosensitive layer may be embedded between two electrodes of different types. However, in semiconducting materials, such as crystalline silicon, crystalline germanium, or a crystalline silicon-germanium alloy, in which the charge carriers can freely move over large distances and, thus, exhibit a long mean-free path, it may also be advantageous to individually apply the two electrodes of different types to separate locations on a single side of the photosensitive layer, in particular as back contacts with regard to the incident light. For further details, reference may be made, e.g., to K. Yoshikawa, H. Kawasaki, W. Yoshida, T. Irie, K. Konishi, K. Nakano, T. Uto, D. Adachi, M. Kanematsu, H. Uzu, and K. Yamamoto, Silicon heterojunction solar cell with interdigitated back contacts for a photoconversion efficiency over 26 %, Nature Energy, Vol. 2, Art. No. 17032, 2017, wherein the photoconversion efficiency of silicon solar cells may be increased by applying the electrodes as back contacts.

In particular, the one or more electrodes which are located outside a path of the light beam designed for impinging on the photosensitive layer may be optically intransparent and, preferably, reflective in order to allow increasing the illumination within the photosensitive layer. In this particular embodiment, the at least one optically intransparent electrode may, preferably, comprise an optically intransparent material, specifically a metal, in particular one or more of silver, platinum, gold, aluminum, titanium, chromium, or molybdenum, or, as an alternative, an alloy thereof. However, further electrode materials may also be feasible. In order to increase the mechanical stability of the optically intransparent electrode when using as little electrode material as possible, the metal electrode may comprise a thin metal layer deposited onto a corresponding substrate. Preferably, the thin metal layer may exhibit a thickness of 10 nm to 1000 nm, preferably of 50 nm to 500 nm, in particular of 100 nm to 250 nm. Herein, the collection layer as described below in more detail may be used as the substrate.

In particular, in order to increase the illumination of the photosensitive layer, the optical sensor may comprise a split electrode having at least two partial electrodes. Generally, the term "partial electrode" refers to an electrode out of a plurality of, preferably identical, electrodes, which are separated from each other and being adapted for measuring at least one current and/or voltage signal, preferably independent from other partial electrodes. Thus, in case a plurality of partial electrodes is provided, the respective electrode is adapted to provide a plurality of electric potentials and/or electric currents and/or voltages via the at least two partial electrodes, which may be measured and/or used independently. However, other kinds of arrangements may also be feasible. Further, spaces between the partial electrodes may allow the incident light beam to pass beside the partial electrodes in order to illuminate the photosensitive layer.

Specifically, for improving an electronic contact to a layer underneath, the electrode, in particular, the split electrode having the at least two partial electrodes which may each comprise a metal contact, may be arranged on top of one of the collection layer. In particular for a purpose of facilitating the light beam to impinge the photosensitive layer for generating the desired charge carriers, the collection layer located within the path of the incident light beam, may, thus, at least partially be optically transparent. Preferably, the at least partially optically transparent electrode may comprise at least one transparent conductive oxide (TCO), in particular at least one of indium-doped tin oxide (ITO), fluorine-doped tin oxide (FTO), or aluminum-doped zinc oxide (AZO). However, other kinds of optically transparent materials which may be suitable as electrode material may also be applicable.

According to the present invention, a first extraction rate for an extraction of the first type of the charge carriers from the photosensitive layer differs from a second extraction rate for the extraction of the second type of the charge carriers from the photosensitive layer. Hence, charge carriers are retained in the active layer. As generally used, the term "extraction" describes a process during which charge carriers, after being generated within the photosensitive layer, are driven in order to perform a movement from the photosensitive layer to one or more different locations which are here, depending on the type of the charge carrier, the first electrode or the second electrode, wherein an attractive electrical potential being present between the first electrode and the second electrode may act as a driving force influencing the movement of the respective charge carriers. Not wishing to be bound by theory, it can reasonably be assumed that the charge carriers are driven by a driving force that may be generated by a gradient of a concentration of the respective charge carriers between a boundary region where the charge carriers are generated and the respective electrode where they leave the optical sensor.

Herein, the term "extraction rate" describes a proportional amount of the charge carriers extracted from the photosensitive layer over a time interval in a particular direction. Consequently, a first extraction rate may be used for describing the proportional amount of the first type of charge carriers extracted from the photosensitive layer to the first electrode, whereas a second extraction rate may be used for describing the proportional amount of the second type of charge carriers extracted from the photosensitive layer to the second electrode. As indicated above, a first extraction rate for the first type of the charge carriers compared to a second extraction rate for the second type of the charge carriers differs from each other, thus resulting in an asymmetric behavior of the charge carriers upon illumination of the photosensitive layer.

However, charge recombination can also be observed in such kinds of devices, wherein the charge recombination can be considered as an opposing process which in is competition with the above-indicated process of charge extraction. As generally used, the term "charge recombination" refers, thus, to a process by which opposing types of charge carriers, i.e. electrons and holes, are recombined, on one hand, in particular, at a surface of the photosensitive layer or, on the other hand, within a bulk of the photosensitive layer, whereby a number of charge carriers of each type are, consequently, reduced. As a particular means to suppress charge recombination, a passivation layer as described below in more detail can be used designed in order to reduce the surface recombination. As a result, a suppression of the charge recombination can be designated to lead to a more dominant role of the charge extraction, which can also be expressed by the extraction rate for the respective type of the charge carriers.

As already indicated above, the two different types of the charge carriers are extractable from the photosensitive layer, wherein, however, the respective extraction rates differ with respect to each other. Herein, the different extraction rates for the two different types of the charge carriers can, in general, be achieved by a particular design of the sensor region comprised by the optical sensor. In a first embodiment, an energetic barrier may be provided between the photosensitive layer and at least one adjacent layer, wherein any one of the terms "energetic barrier" or "extraction barrier" refers to a difference in energy levels between adjacent charge transport levels of the corresponding charge carriers at least 0.1 eV, in particular in order to exceed an available thermal energy at room temperature, preferably at least 0.3 eV, specifically at least 0.5 eV up to 0.6 eV. In an alternative embodiment, at least one adjacent layer which is located between the photosensitive layer and the respective electrode which is designed for collecting the corresponding first type of charge carriers may exhibit a lower electrical conductivity for one of the two types of the charge carriers with respect to the photosensitive layer, wherein the term "low electrical conductivity", particularly, refers to an electrically conductivity below the electrical conductivity of the semiconducting material within the photosensitive layer but still above 10⁻⁶ S/cm, preferably above 10⁻⁵ S/cm, more preferred above 10⁻⁴ S/cm.

Thus, by the particular design of the sensor region, the difference in the extraction rates for the two types of the charge carriers can be sustained. As indicated above, a sustaining difference can, preferably, be achieved either by an extraction barrier or by a low electrical conductivity layer located between the photosensitive layer and the corresponding electrode. Without wishing to be bound by theory, in an initial phase upon illuminating the sensor region of the optical sensor, the type of the charge carriers which faces the lower extraction barrier can more easily be extracted from the photosensitive layer for advancing to the corresponding electrode. In contrast hereto, the other type of the charge carriers which remain in the photosensitive layer may accumulate at a boundary of the photosensitive layer to the extraction layer, wherein their respective charges are, however, due to reasons of charge neutrality compensated by countercharges of opposite sign being provided at the other side of the extraction layer away from the photosensitive layer and/or at the electrode. After the initial phase upon illuminating the sensor region has passed, a reduction of the sensor signal, such as of the sensor current, generated by the optical sensor may, thus, be observable since the generation of the sensor signal is limited by the charge extraction over the higher extraction barrier. As indicated above, the sensor signal and, hence, the reduction thereof depends on the illumination of the sensor region. As a result, at higher illumination levels, at which higher charge carrier concentrations are generated, a larger ratio of charge carriers may recombine instead of being extracted from the device compared to lower illumination levels. Consequently, a minimum of the extracted sensor signal, such as a sensor current, may be obtained at a maximum of the illumination of the sensor region which can be achieved by impinging the semiconductive material in the photosensitive layer by a light beam with the smallest possible cross-section, such as when the material may be located at or near a focal point as affected by an optical lens. Thus, the optical sensor having the photosensitive layer within the sensor region according to the present invention, exhibits the FiP effect, in particular, the negative FiP effect. Thus, as further used herein, the terms "sustaining" or "sustainingly" refer to an observation that the different extraction rates for the different types of the charge carriers which are extractable from the photosensitive layer remain different during an initial phase. As generally known, the FiP effect can be observed in a geometry dependence of the sensor signals on the illumination of the sensor region, such as described in WO 2012/110924 A1 and WO 2014/097181 A1 in more detail. This behavior is in contrast to traditional optical sensors, such as a silicon photo detectors or a germanium photo detector as disclosed in WO 2012/110924 A1 and WO 2014/097181 A1, in which the sensor signals of the corresponding detectors have been found not to exhibit the FiP effect by being independent from a cross-section of an incident light illuminating the sensor region. As illustrated in Figure 2 of WO 2012/110924 A1 and in Figure 4A of WO 2014/097181 A1, the silicon photo detector or the germanium photo detector used therein have been provided in a manner that the extraction barriers for both types of the charge carriers are low with respect to the available thermal energy, thus, resulting in an absence of the FiP effect in these kinds of optical detectors.

In a preferred embodiment, the difference in extraction rate may be achieved by providing, on one hand, a first extraction layer which may be arranged between the photosensitive layer and the first electrode and, on the other hand, by providing a second extraction layer which may be arranged between the photosensitive layer and the second electrode, wherein the two extraction layers may lead to a difference in extraction rates for extracting the first type of charge carriers compared to the second type of charge carriers from the photosensitive layer, wherein the difference can be sustained in a sense as defined above. As used herein, the term "extraction layer" refers to a layer which is designed for extracting a particular type of charge carriers, i.e. electrons or holes, from the photosensitive layer. As a result, the first extraction rate defined as the rate for extracting the first type of charge carriers from the photosensitive layer differs from the second extraction rate defined as the rate for extracting the second type of charge carriers from the photosensitive layer.

In a particularly preferred embodiment, the extraction layer may comprise at least one semiconducting absorber layer. For this purpose, the semiconducting absorber layer may be or comprise a layer of doped amorphous silicon, in particular, in an embodiment in which the photosensitive layer comprises crystalline silicon. The layer of doped amorphous silicon can, preferably, be obtained by depositing doped amorphous silicon as a layer, especially as a thin film, on an appropriate substrate, specifically, on the photosensitive layer or on a layer deposited on the photosensitive layer, such as a passivation layer as described below in more detail. However, other methods may be applicable, such as depositing amorphous silicon as a layer and performing a doping process thereafter. Herein, a kind of doping of the extraction layer depends on the kind of the charge carriers, in particular, p-doped amorphous silicon or "p:a-Si" may, specifically, be used for a hole extraction layer, while n-doped amorphous silicon or "n:a-Si" may, specifically, be used for an electron extraction layer.

In a further preferred embodiment, a relative height of the extraction barrier can be adjusted by adjusting an offset in charge transport levels between adjacent layers, in particular by adjusting the charge transport level of the photosensitive layer with respect to the charge transport level of an adjacent layer, specifically an extraction layer and/or a passivation layer. Herein, adjusting the offset in the charge transport levels between the adjacent layers can, in general, be performed by selecting appropriate materials for the adjacent layers, in particular, of any one of the photosensitive layer, the extraction layer and/or a passivation layer. For this purpose, the photosensitive layer can, in this preferred embodiment, be adjusted by selecting a particular composition of the semiconducting material as used for the photosensitive layer. In a first embodiment, a ratio of sulfur (S) and selenium (Se) in CZTSSe can be selected, wherein CZTSSe can also be considered as a blend of copper zinc tin sulfide (CZTS) and copper zinc tin selenide (CZTSe) that may be expressed, in a simplified manner, by a molecular formula of Cu₂ZnSnS₄₋ₓSeₓ, wherein 0 < x < 4. Herein, a ratio of S to Se may determine a height of the charge transport level and the bandgap within the photosensitive layer. Specifically, a higher amount of Se in CZTSSe may, in general, lead to a smaller bandgap and, thus, to a larger height of the extraction barrier for the extraction of electrons through an adjacent layer of cadmium sulfide (CdS). In a further embodiment, chemical structures of one or more molecules as, typically, used in organic solar cells can be altered in order to adjust the height of the charge transport level in the respective layer. Further, the height of the charge transport level can also be adjusted by blending one or more selected organic materials into the photosensitive layer. As a result of any one of these embodiments, the relative height of the extraction barrier with respect to the photosensitive layer and the adjacent extraction layer can, thus, be adjusted, specifically in order to create in this manner the extraction barrier that has a desired height for the respective charge carriers.

Further, as already indicated above, the photosensitive layer may, preferably, be separated from at least one of the electrodes by a passivation layer being provided herein, preferably, between the photosensitive layer and the extraction layer. As generally used, the "passivation layer" refers to a further semiconductive layer or a layer having a low electrical conductivity which is designed for reducing the process of charge recombination of opposing types of charge carriers, i.e. electrons and holes, at the surface of the photosensitive layer, which competes with the process of charge extraction, whereby the charge extraction from the photosensitive layer and, specifically, the corresponding extraction rate may, therefore, be improved. For this purpose, intrinsic amorphous silicon or "i:a-Si" may be used, specifically intrinsic amorphous silicon that can be passivated by applying hydrogen, in particular, in a manner that a number of dangling bonds within the intrinsic amorphous silicon may be reduced by several orders of magnitude. As a result, intrinsic hydrogenated amorphous silicon, also abbreviated to "i:a-Si:H", may be obtained, which exhibits a low amount of defects, thus, being well-suited for optical devices. As alternatives, an amorphous alloy of silicon and carbon (a-SiC) may, preferably, be passivated to a hydrogenated amorphous silicon carbon alloy (a-SiC:H), or an amorphous silicon-germanium alloy (a-GeSi) may, alternatively, be passivated to a hydrogenated amorphous germanium silicon alloy (a-GeSi:H). Herein, a-GeSi:H may, preferably, be produced by using SiH₄, GeH₄, and H₂ as process gases within a common reactor, wherein, however, other production methods may be feasible.

As a further alternative for the passivation layer, a thin electrically non-conductive layer may be used, in particular, as described by M.A. Green, Solar Energy Materials & Solar Cells 143, 2015, pp. 190-197. However, other production methods may also be applicable.

In an alternative, particularly preferred embodiment, the arrangement of the sensor region which results in a difference in extraction rates for the two different types of the charge carriers being extractable from the photosensitive layer may be achieved by a barrier located within the optical sensor. Due to this barrier, charge carriers are retained in the photosensitive layer. As used herein, the term "barrier" refers to a particular type of arrangement of the respective partitions and layers of the optical sensor in a manner that the extraction rate for the type of the charge carriers for which the adjacent electrode is designed for collecting is limited, in particular, by generating a repulsive electrical potential between the photosensitive layer and one of the electrodes. By way of example, a hole barrier may, thus, be generated by providing a repulsive electrical potential for holes between the photosensitive layer and the electrode designed for collecting holes, such as by the first electrode, while an electron barrier may, alternatively, be generated by providing a repulsive electrical potential for electrons between the photosensitive layer and the electrode designed for collecting electrons, such as by the second electrode. Herein, the photosensitive layer may, preferably, be separated from one of the first electrode or the second electrode by at least one barrier, wherein no extraction layer may be provided between the photosensitive layer and the corresponding electrode. Consequently, the photosensitive layer having two opposing side may, preferably, be sandwiched, on one side, by a single extraction layer and, on the other side, by a single barrier both designated for the same type of charge carriers. As a result, the first extraction rate for the first type of the charge carriers compared to the second extraction rate for the second type of the charge carriers differs from each other, whereby an asymmetric behavior of the charge carriers upon illumination of the photosensitive layer can be achieved at least over a considerable time after the illumination of the sensor region.

In a first embodiment, the barrier comprises an arrangement, in which the photosensitive layer directly adjoins the corresponding electrode or, preferably, a collection layer located adjacently with respect to both the photosensitive layer and the corresponding electrode. As a result of an interaction between the semiconducting photosensitive layer and the adjacent electrode material, a so-called "Schottky barrier" or "Schottky contact" may, thus, spontaneously be formed. In order to achieve transparency of the optical sensor, thus, allowing the light beam to arrive at the photosensitive layer, the Schottky barrier can, preferably, be arranged in a manner that it may be located away from a direction where the light beam is designated to enter the optical sensor.

In an alternative embodiment, the barrier may be provided in form of a separate, individual blocking layer. As generally used, the term "blocking layer" refers to a layer of material which is designated for impeding a transport of one at least one type of charge carriers, specifically, by being adapted to influence a path of permeating electrically conducting particles, in particular of electrons or holes, with respect to the adjacent layers in an electronic element, such as to prevent a short-circuiting of the adjacent layers or to prevent a recombination of permeating conductive particles as provided by one of the adjacent layers with oppositely charged particles, such as the charge carriers of opposing charge, located in the other of the adjacent layers. By way of example, a hole blocking layer may be designed for impeding the transport of holes while an electron blocking layer may be designed for impeding the transport of electron. Herein, the blocking layer may, in particular, comprise a thin film of an electrically conducting material having a low electrical conductivity as defined above, in particular one or more of an oxide, specifically silicon dioxide (SiO₂), titanium dioxide (TiO₂), zinc oxide (ZnO), aluminum oxide (Al₂O₃), zirconium dioxide (ZrO₂), or molybdenum oxide (MoO₃), or of a nitride, specifically of silicon nitride (Si₃N₄). For this purpose, further kinds of materials, such as a polymer film, may, however, also be feasible. By locating such a designated blocking layer into the optical sensor, a height of the barrier and hence a performance of the optical sensor, specifically, with regard to an occurrence of the FiP effect, can be adjusted.

When designing a particular embodiment of the detector according to the present invention, the skilled person may, typically, consider arranging the various layers having intransparent, partially transparent or transparent optical properties in a fashion that the incident light beam can actually reach the photosensitive layer within the optical sensor. Thus, those layers which are arranged within a path of the incident light beam may, preferably, be transparent, i.e. they may exhibit a transmittance which may be capable of decreasing the illumination power of the incident light beam as little as possible over at least a partition of a spectral range of the incident light beam. As generally used, the term "transmittance" refers to a fraction of an incident illumination power which may be transmitted through a layer. By way of example, the incident light beam may, first, traverse a transparent substrate, such as a substrate comprising glass, quartz, or a solid, transparent organic substance, and, subsequently, a transparent electrode and/or a collection layer, which may comprise a transparent conducting oxide (TCO) as described above in more detail, and, optionally, a blocking layer, which may comprise transparent silicon oxide (SiO₂) until it may reach the photosensitive layer. As a further example, the incident light beam may, first, traverse the transparent substrate, the transparent electrode and, if applicable, the transparent collection layer and, subsequently, an at least partially transparent extraction layer, and, if applicable, an at least partially transparent passivation layer until it may actually reach the photosensitive layer. Restrictions as indicated above with regard to possible Schottky barriers can, hereby, be taken into account. Further embodiments which may incorporate additional layers and/or alternative arrangements may also be conceivable.

In general, the at least one incident light beam impinging the sensor region may be a constant light beam at least over a predefined time interval. However, in a particular embodiment, the at least one incident light beam impinging the sensor region may be a modulated light beam. Accordingly, the detector according to the present invention may comprise at least one modulation device which may be capable of generating the modulated light beam traveling from the object to the detector and, thus, modulates the illumination of the object and/or at least one sensor region of the detector, such as at least one sensor region of the at least one longitudinal optical sensor. Preferably, the modulation device may be employed for generating a periodic modulation, such as by employing a periodic beam interrupting device. By way of example, the detector can be designed to bring about a modulation of the illumination of the object and/or at least one sensor region of the detector, such as at least one sensor region of the at least one longitudinal optical sensor, with a frequency of 0.05 Hz to 1 MHz, such as 0.1 Hz to 100 kHz. Within this regard, the term "modulation of the illumination" is understood to refer to a process in which a total power of the illumination is varied, preferably periodically, in particular with a single modulation frequency or, simultaneously and/or consecutively, with a plurality of modulation frequencies. In particular, a periodic modulation can be effected between a maximum value and a minimum value of the total power of the illumination. Herein, the minimum value can be 0, but can also exceed 0, such that, by way of example, complete modulation does not have to be effected. In a particularly preferential manner, the at least one modulation may be or may comprise a periodic modulation, such as a sinusoidal modulation, a square modulation, or a triangular modulation of the affected light beam. Further, the modulation may be a linear combination of two or more sinusoidal functions, such as a squared sinusoidal function, or a sin(t²) function, where t denotes time. In order to demonstrate particular effects, advantages and feasibility of the present invention the square modulation is, in general, employed herein as an exemplary shape of the modulation which representation is, however, not intended to limit the scope of the present invention to this specific shape of the modulation. By virtue of this example, the skilled person may rather easily recognize how to adapt the related parameters and conditions when employing a different shape of the modulation.

In a particular embodiment, the modulation can be effected for example in a beam path between the object and the optical sensor, for example by the at least one modulation device being arranged in said beam path. Alternatively or additionally, however, the modulation can also be effected in a beam path between an optional illumination source as described below for illuminating the object and the object, for example by the at least one modulation device being arranged within said beam path. A combination of these possibilities may also be conceivable. For this purpose, the at least one modulation device can comprise, for example, a beam chopper or some other type of periodic beam interrupting device, such as comprising at least one interrupter blade or interrupter wheel, which preferably rotates at constant speed and which can, thus, periodically interrupt the illumination. Alternatively or additionally, however, it is also possible to use one or a plurality of different types of modulation devices, for example modulation devices based on an electro-optical effect and/or an acousto-optical effect. Once again alternatively or additionally, the at least one optional illumination source itself can also be designed to generate a modulated illumination, for example by the illumination source itself having a modulated intensity and/or total power, for example a periodically modulated total power, and/or by said illumination source being embodied as a pulsed illumination source, for example as a pulsed laser. Thus, by way of example, the at least one modulation device can also be wholly or partly integrated into the illumination source. Further, alternatively or in addition, the detector may comprise at least one optional transfer device, such as a tunable lens, which may itself be designed to modulate the illumination, for example by modulating, in particular by periodically modulating, the total intensity and/or total power of an incident light beam which impinges the at least one transfer device in order to traverse it before impinging the at least one longitudinal optical sensor. Various possibilities are feasible.

Further, given the same total power of the illumination, the sensor signal may, thus, be dependent on the modulation frequency of the modulation of the illumination. For potential embodiments of the longitudinal optical sensor and the longitudinal sensor signal, including its dependency on the beam cross-section of the light beam within the sensor region and on the modulation frequency, reference may be made to the optical sensor as disclosed in WO 2012/110924 A1 and 2014/097181 A1. Within this respect, the detector can be designed in particular to detect at least two sensor signals in the case of different modulations, in particular at least two longitudinal sensor signals at respectively different modulation frequencies. The evaluation device can be designed to generate the geometrical information from the at least two longitudinal sensor signals. As described in WO 2012/110924 A1 and WO 2014/097181 A1, it may be possible to resolve ambiguities and/or it is possible to take account of the fact that, for example, a total power of the illumination is generally unknown.

As further used herein, the term "evaluation device" generally refers to an arbitrary device designed to generate the items of information, i.e. the at least one item of information on the position of the object. As an example, the evaluation device may be or may comprise one or more integrated circuits, such as one or more application-specific integrated circuits (ASICs), and/or one or more data processing devices, such as one or more computers, preferably one or more microcomputers and/or microcontrollers. Additional components may be comprised, such as one or more preprocessing devices and/or data acquisition devices, such as one or more devices for receiving and/or preprocessing of the sensor signals, such as one or more AD-converters and/or one or more filters. As used herein, the sensor signal may generally refer to one of the longitudinal sensor signal or to the transversal sensor signal. Further, the evaluation device may comprise one or more data storage devices. Further, as outlined above, the evaluation device may comprise one or more interfaces, such as one or more wireless interfaces and/or one or more wire-bound interfaces. The at least one evaluation device may be adapted to perform at least one computer program, such as at least one computer program performing or supporting the step of generating the items of information. As an example, one or more algorithms may be implemented which, by using the sensor signals as input variables, may perform a predetermined transformation into the position of the object.

The evaluation device may particularly comprise at least one data processing device, in particular an electronic data processing device, which can be designed to generate the items of information by evaluating the sensor signals. Thus, the evaluation device is designed to use the sensor signals as input variables and to generate the items of information on the longitudinal position and/or on the transversal position of the object by processing these input variables. The processing can be done in parallel, subsequently or even in a combined manner. The evaluation device may use an arbitrary process for generating these items of information, such as by calculation and/or using at least one stored and/or known relationship. Besides the sensor signals, one or a plurality of further parameters and/or items of information can influence said relationship, for example at least one item of information about a modulation frequency. The relationship can be determined or determinable empirically, analytically or else semi-empirically. Particularly preferably, the relationship comprises at least one calibration curve, at least one set of calibration curves, at least one function or a combination of the possibilities mentioned. One or a plurality of calibration curves can be stored for example in the form of a set of values and the associated function values thereof, for example in a data storage device and/or a table. Alternatively or additionally, however, the at least one calibration curve can also be stored for example in parameterized form and/or as a functional equation. Separate relationships for processing the sensor signals into the items of information may be used. Alternatively, at least one combined relationship for processing the sensor signals is feasible. Various possibilities are conceivable and can also be combined.

By way of example, the evaluation device can be designed in terms of programming for the purpose of determining the items of information. The evaluation device can comprise in particular at least one computer, for example at least one microcomputer. Furthermore, the evaluation device can comprise one or a plurality of volatile or nonvolatile data memories. As an alternative or in addition to a data processing device, in particular at least one computer, the evaluation device can comprise one or a plurality of further electronic components which are designed for determining the items of information, for example an electronic table and in particular at least one look-up table and/or at least one application-specific integrated circuit (ASIC).

The detector has, as described above, at least one evaluation device. In particular, the at least one evaluation device can also be designed to completely or partly control or drive the detector, for example by the evaluation device being designed to control at least one illumination source and/or to control at least one modulation device of the detector as described below in more detail. The evaluation device can be designed, in particular, to carry out at least one measurement cycle in which one or a plurality of sensor signals, such as a plurality of sensor signals, are picked up, for example a plurality of sensor signals of successively at different modulation frequencies of the illumination.

The evaluation device is designed, as described above, to generate at least one item of information on the position of the object by evaluating the at least one sensor signal. The position of the object can be static or may even comprise at least one movement of the object, for example a relative movement between the detector or parts thereof and the object or parts thereof. In this case, a relative movement can generally comprise at least one linear movement and/or at least one rotational movement. Items of movement information can for example also be obtained by comparison of at least two items of information picked up at different times, such that for example at least one item of location information can also comprise at least one item of velocity information and/or at least one item of acceleration information, for example at least one item of information about at least one relative velocity between the object or parts thereof and the detector or parts thereof. In particular, the at least one item of location information can generally be selected from: an item of information about a distance between the object or parts thereof and the detector or parts thereof, in particular an optical path length; an item of information about a distance or an optical distance between the object or parts thereof and the optional transfer device or parts thereof; an item of information about a positioning of the object or parts thereof relative to the detector or parts thereof; an item of information about an orientation of the object and/or parts thereof relative to the detector or parts thereof; an item of information about a relative movement between the object or parts thereof and the detector or parts thereof; an item of information about a two-dimensional or three-dimensional spatial configuration of the object or of parts thereof, in particular a geometry or form of the object. Generally, the at least one item of location information can therefore be selected for example from the group consisting of: an item of information about at least one location of the object or at least one part thereof; information about at least one orientation of the object or a part thereof; an item of information about a geometry or form of the object or of a part thereof, an item of information about a velocity of the object or of a part thereof, an item of information about an acceleration of the object or of a part thereof, an item of information about a presence or absence of the object or of a part thereof in a visual range of the detector. Herein, the at least one item of location information can be specified for example in at least one coordinate system, for example a coordinate system in which the detector or parts thereof rest. Alternatively or additionally, the location information can also simply comprise for example a distance between the detector or parts thereof and the object or parts thereof. Combinations of the possibilities mentioned are also conceivable.

As described above, the detector according to the present invention may, preferably, comprise a single individual longitudinal optical sensor. However, in a particular embodiment, such as when the different longitudinal optical sensors may exhibit different spectral sensitivities with respect to the incident light beam, the detector may comprise two or more longitudinal optical sensors, wherein each longitudinal optical sensor may be adapted to generate at least one longitudinal sensor signal. As an example, the sensor areas or the sensor surfaces of the longitudinal optical sensors may, thus, be oriented in parallel, wherein slight angular tolerances might be tolerable, such as angular tolerances of no more than 10°, preferably of no more than 5°. Herein, preferably all of the longitudinal optical sensors of the detector, which may, preferably, be arranged in form of a stack along the optical axis of the detector, may be transparent. Thus, the light beam may pass through a first transparent longitudinal optical sensor before impinging on the other longitudinal optical sensors, preferably subsequently. Thus, the light beam from the object may subsequently reach all longitudinal optical sensors present in the optical detector.

Further, the detector according to the present invention may comprise a stack of optical sensors as disclosed in WO 2014/097181 A1, in particular in a combination of one or more longitudinal optical sensors with one or more transversal optical sensors. As an example, one or more transversal optical sensors may be located on a side of the at least one longitudinal optical sensor facing towards the object. Alternatively or additionally, one or more transversal optical sensors may be located on a side of the at least one longitudinal optical sensor facing away from the object. Again, additionally or alternatively, one or more transversal optical sensors may be interposed in between at least two longitudinal optical sensors arranged within the stack. Further, the stack of optical sensors may be a combination of a single individual longitudinal optical sensor with a single individual transversal optical sensor. However, an embodiment which may only comprise a single individual longitudinal optical sensor and no transversal optical sensor may still be advantageous, such as in a case in which determining solely the depth of the object may be desired.

As mentioned above, the detector for optical detection, in particular, for determining the position of the at least one object may, specifically, be designated for determining a longitudinal position (depth) of the at least one object. Thus, a detector for determining the transversal position (width) of the at least one object, also denominated as "transversal optical sensor", may be used in addition to the longitudinal optical sensor as described herein. As used herein, the term "transversal optical sensor" generally refers to a device which is adapted to determine a transversal position of at least one light beam traveling from the object to the detector. With regard to the term position, reference may be made to the definition above. Preferably, a known transversal optical sensor, such as in addition to a known position sensitive device (PSD), such as a photo detector according as disclosed in WO 2012/110924 A1 or WO 2014/097181 A1, or a photoconductor as described in WO 2016/120392 A1, can be applied for this purpose. However, further kinds of transversal optical sensors may also be applicable.

Further embodiments of the present invention referred to the nature of the light beam which propagates from the object to the detector. As used herein, the term "light" generally refers to electromagnetic radiation in one or more of the visible spectral range, the ultraviolet spectral range and the infrared spectral range. Therein, the term visible spectral range generally refers to a spectral range of 380 nm to 780 nm. The term infrared (IR) spectral range generally refers to electromagnetic radiation of 780 nm to 1000 µm, wherein the range of 780 nm to 1.5 µm is usually denominated as near infrared (NIR) spectral range, the range of 1.5 µm to 15 µm as mid infrared range (midIR), and the range from 15 µm to 1000 µm as far infrared (FIR) spectral range. The term ultraviolet spectral range generally refers to electromagnetic radiation 1 nm to 380 nm, especially of 100 nm to 380 nm. Preferably, light as used with respect to the present invention is light which may be absorbed by the semiconducting material as comprised by the photosensitive layer, in particular by crystalline silicon, crystalline germanium, crystalline silicon-germanium alloys, or doped variants thereof, specifically of 300 nm to 1200 nm for crystalline silicon and of 300 nm to 1800 nm for crystalline germanium.

The term "light beam" generally refers to an amount of light emitted into a specific direction. Thus, the light beam may be a bundle of the light rays having a predetermined extension in a direction perpendicular to a direction of propagation of the light beam. Preferably, the light beam may be or may comprise one or more Gaussian light beams which may be characterized by one or more Gaussian beam parameters, such as one or more of a beam waist, a Rayleigh-length or any other beam parameter or combination of beam parameters suited to characterize a development of a beam diameter and/or a beam propagation in space. The light beam might be admitted by the object itself, i.e. might originate from the object. Additionally or alternatively, another origin of the light beam is feasible. Thus, as will be outlined in further detail below, one or more illumination sources might be provided which illuminate the object, such as by using one or more primary rays or beams, such as one or more primary rays or beams having a predetermined characteristic. In the latter case, the light beam propagating from the object to the detector might be a light beam which is reflected by the object and/or a reflection device connected to the object.

As outlined above, the at least one longitudinal sensor signal, given the same total power of the illumination by the light beam, is, according to the FiP effect, dependent on a beam cross-section of the light beam in the sensor region of the at least one longitudinal optical sensor. As used herein, the term beam cross-section generally refers to a lateral extension of the light beam or a light spot generated by the light beam at a specific location. In case a circular light spot is generated, a radius, a diameter or a Gaussian beam waist or twice the Gaussian beam waist may function as a measure of the beam cross-section. In case non-circular light-spots are generated, the cross-section may be determined in any other feasible way, such as by determining the cross-section of a circle having the same area as the non-circular light spot, which is also referred to as the equivalent beam cross-section. In this regard, it may be possible to employ the observation of an extremum, i.e. a maximum or a minimum, of the longitudinal sensor signal, in particular a global extremum, under a condition in which the material in the photosensitive layer may be impinged by a light beam with the smallest possible cross-section, such as when the material may be located at or near a focal point as affected by an optical lens. In case the extremum is a maximum, this observation may be denominated as the "positive FiP effect", while in case the extremum is a minimum, this observation may be denominated as the "negative FiP effect". As demonstrated in an example below, the optical sensor having the photosensitive layer within the sensor region according to the present invention, exhibits the FiP effect, in particular, the negative FiP effect as explained above in more detail.

Thus, irrespective of the material actually comprised in the sensor region but given the same total power of the illumination of the sensor region by the light beam, a light beam having a first beam diameter or beam cross-section may generate a first longitudinal sensor signal, whereas a light beam having a second beam diameter or beam-cross section being different from the first beam diameter or beam cross-section generates a second longitudinal sensor signal being different from the first longitudinal sensor signal. As described in WO 2012/110924 A1, by comparing the longitudinal sensor signals, at least one item of information on the beam cross-section, specifically on the beam diameter, may be generated. Accordingly, the longitudinal sensor signals generated by the longitudinal optical sensors may be compared, in order to gain information on the total power and/or intensity of the light beam and/or in order to normalize the longitudinal sensor signals and/or the at least one item of information on the longitudinal position of the object for the total power and/or total intensity of the light beam. Thus, as an example, a minimum value of the longitudinal optical sensor signals may be detected, and all longitudinal sensor signals may be divided by this minimum value, thereby generating normalized longitudinal optical sensor signals, which, then, may be transformed by using the above-mentioned known relationship, into the at least one item of longitudinal information on the object. Other ways of normalization are feasible, such as a normalization using a mean value of the longitudinal sensor signals and dividing all longitudinal sensor signals by the mean value. Other options are possible.

This embodiment may, particularly, be used by the evaluation device in order to resolve an ambiguity in the known relationship between a beam cross-section of the light beam and the longitudinal position of the object. Thus, even if the beam properties of the light beam propagating from the object to the detector are known fully or partially, it is known that, in many beams, the beam cross-section narrows before reaching a focal point and, afterwards, widens again. Thus, before and after the focal point in which the light beam has the narrowest beam cross-section, along the axis of propagation of the light beam positions occur in which the light beam has the same cross-section. Thus, as an example, at a distance z0 before and after the focal point, the cross-section of the light beam is identical. Thus, in case the optical detector only comprises a single longitudinal optical sensor, a specific cross-section of the light beam might be determined, in case the overall power or intensity of the light beam is known. By using this information, the distance z0 of the respective longitudinal optical sensor from the focal point might be determined. However, in order to determine whether the respective longitudinal optical sensor may be located before or behind the focal point, additional information is required, such as a history of movement of the object and/or the detector and/or information on whether the detector is located before or behind the focal point.

In case one or more beam properties of the light beam propagating from the object to the detector are known, the at least one item of information on the longitudinal position of the object may thus be derived from a known relationship between the at least one longitudinal sensor signal and a longitudinal position of the object. The known relationship may be stored in the evaluation device as an algorithm and/or as one or more calibration curves. As an example, specifically for Gaussian beams, a relationship between a beam diameter or beam waist and a position of the object may easily be derived by using the Gaussian relationship between the beam waist and a longitudinal coordinate. Thus, as described in WO 2014/097181 A1, the evaluation device according to the present invention may be adapted to compare the beam cross-section and/or the diameter of the light beam with known beam properties of the light beam in order to determine the at least one item of information on the longitudinal position of the object, preferably from a known dependency of a beam diameter of the light beam on at least one propagation coordinate in a direction of propagation of the light beam and/or from a known Gaussian profile of the light beam.

In addition to the at least one longitudinal coordinate of the object, at least one transversal coordinate of the object may be determined. Thus, generally, the evaluation device may further be adapted to determine at least one transversal coordinate of the object by determining a position of the light beam on the at least one transversal optical sensor, which may be a pixelated, a segmented or a large-area transversal optical sensor, as further outlined also in WO 2014/097181 A1.

In addition, the detector may comprise at least one transfer device, such as an optical lens, in particular one or more refractive lenses, particularly converging thin refractive lenses, such as convex or biconvex thin lenses, and/or one or more convex mirrors, which may further be arranged along the common optical axis. Most preferably, the light beam which emerges from the object may in this case travel first through the at least one transfer device and thereafter through the single transparent longitudinal optical sensor or the stack of the transparent longitudinal optical sensors until it may finally impinge on an imaging device. As used herein, the term "transfer device" refers to an optical element which may be configured to transfer the at least one light beam emerging from the object to at least one optical sensor within the detector. Thus, the transfer device can be designed to feed light propagating from the object to the optical sensor, wherein this feeding can optionally be effected by means of imaging or else by means of non-imaging properties of the transfer device. In particular the transfer device can also be designed to collect the electromagnetic radiation before the latter is fed to the optical sensor.

In addition, the at least one transfer device may have imaging properties. Consequently, the transfer device comprises at least one imaging element, for example at least one lens and/or at least one curved mirror, since, in the case of such imaging elements, for example, a geometry of the illumination on the sensor region can be dependent on a relative positioning, for example a distance, between the transfer device and the object. As used herein, the transfer device may be designed in such a way that the electromagnetic radiation which emerges from the object is transferred completely to the sensor region, for example is focused completely onto the sensor region, in particular the sensor area, in particular if the object is arranged in a visual range of the detector.

In addition, the transfer device may also be employed for modulating light beams, such as by using a modulating transfer device. Herein, the modulating transfer device may be adapted to modulate the frequency and/or the intensity of an incident light beam before the light beam might impinge on the longitudinal optical sensor. Herein, the modulating transfer device may comprise means for modulating light beams and/or may be controlled by the modulation device, which may be a constituent part of the evaluation device and/or may be at least partially implemented as a separate unit.

Further, the detector may comprise at least one imaging device, i.e. a device capable of acquiring at least one image. The imaging device can be embodied in various ways. Thus, the imaging device can be for example part of the detector in a detector housing. Alternatively or additionally, however, the imaging device can also be arranged outside the detector housing, for example as a separate imaging device. Alternatively or additionally, the imaging device can also be connected to the detector or even be part of the detector. In a preferred arrangement, the at least one optical sensor and the imaging device are aligned along a common optical axis along which the light beam travels. Thus, it may be possible to locate an imaging device in the optical path of the light beam in a manner that the light beam travels through the optical sensor until it impinges on the imaging device. However, other arrangements are possible.

As used herein, an "imaging device" is, generally, understood as a device which can generate a one-dimensional, a two-dimensional, or a three-dimensional image of the object or of a part thereof. In particular, the detector, with or without the at least one optional imaging device, can be completely or partly used as a camera, such as an IR camera, or an RGB camera, i.e. a camera which is designed to deliver three basic colors which are designated as red, green, and blue, on three separate connections. Thus, as an example, the at least one imaging device may be or may comprise at least one imaging device selected from the group consisting of: a pixelated organic camera element, preferably a pixelated organic camera chip; a pixelated inorganic camera element, preferably a pixelated inorganic camera chip, more preferably a CCD-chip or CMOS-chip; a monochrome camera element, preferably a monochrome camera chip; a multicolor camera element, preferably a multicolor camera chip; a full-color camera element, preferably a full-color camera chip. The imaging device may be or may comprise at least one device selected from the group consisting of a monochrome imaging device, a multi-chrome imaging device and at least one full color imaging device. A multi-chrome imaging device and/or a full color imaging device may be generated by using filter techniques and/or by using intrinsic color sensitivity or other techniques, as the skilled person will recognize. Other embodiments of the imaging device are also possible. For further details concerning the imaging device, reference may be made to WO 2014/097181 A1.

Light emerging from the object can originate in the object itself, but can also optionally have a different origin and propagate from this origin to the object and subsequently toward the optical sensors. The latter case can be affected for example by at least one illumination source being used. The illumination source can be embodied in various ways. Thus, the illumination source can be for example part of the detector in a detector housing. Alternatively or additionally, however, the at least one illumination source can also be arranged outside a detector housing, for example as a separate light source. The illumination source can be arranged separately from the object and illuminate the object from a distance. Alternatively or additionally, the illumination source can also be connected to the object or even be part of the object, such that, by way of example, the electromagnetic radiation emerging from the object can also be generated directly by the illumination source. By way of example, at least one illumination source can be arranged on and/or in the object and directly generate the electromagnetic radiation by means of which the sensor region is illuminated. This illumination source can for example be or comprise an ambient light source and/or may be or may comprise an artificial illumination source. By way of example, at least one infrared emitter and/or at least one emitter for visible light and/or at least one emitter for ultraviolet light can be arranged on the object. By way of example, at least one light emitting diode and/or at least one laser diode can be arranged on and/or in the object. The illumination source can comprise in particular one or a plurality of the following illumination sources: a laser, in particular a laser diode, although in principle, alternatively or additionally, other types of lasers can also be used; a light emitting diode; an incandescent lamp; a neon light; a flame source; an organic light source, in particular an organic light emitting diode; a structured light source. Alternatively or additionally, other illumination sources can also be used. It is particularly preferred if the illumination source is designed to generate one or more light beams having a Gaussian beam profile, as is at least approximately the case for example in many lasers. For further potential embodiments of the optional illumination source, reference may be made to one of WO 2012/110924 A1 and WO 2014/097181 A1. Still, other embodiments are feasible.

The at least one optional illumination source generally may emit light in at least one of: the ultraviolet spectral range, preferably of 200 nm to 380 nm; the visible spectral range, i.e. of 380 nm to 780 nm; the infrared spectral range, preferably of 780 nm to 15 µm. Most preferably, the at least one illumination source is adapted to emit light in the IR spectral range, preferably in the range of 1 µ to 15 µm. Herein, it is particularly preferred when the illumination source may exhibit a spectral range which may be related to the spectral sensitivities of the optical sensor, particularly in a manner to ensure that the optical sensor which may be illuminated by the respective illumination source may provide a sensor signal with a high intensity which may, thus, enable a high-resolution evaluation with a sufficient signal-to-noise-ratio.

In a further aspect of the present invention, a human-machine interface for exchanging at least one item of information between a user and a machine is proposed. The human-machine interface as proposed may make use of the fact that the above-mentioned detector in one or more of the embodiments mentioned above or as mentioned in further detail below may be used by one or more users for providing information and/or commands to a machine. Thus, preferably, the human-machine interface may be used for inputting control commands.

The human-machine interface comprises at least one detector according to the present invention, such as according to one or more of the embodiments disclosed above and/or according to one or more of the embodiments as disclosed in further detail below, wherein the human-machine interface is designed to generate at least one item of geometrical information of the user by means of the detector wherein the human-machine interface is designed to assign the geometrical information to at least one item of information, in particular to at least one control command.

In a further aspect of the present invention, an entertainment device for carrying out at least one entertainment function is disclosed. As used herein, an entertainment device is a device which may serve the purpose of leisure and/or entertainment of one or more users, in the following also referred to as one or more players. As an example, the entertainment device may serve the purpose of gaming, preferably computer gaming. Additionally or alternatively, the entertainment device may also be used for other purposes, such as for exercising, sports, physical therapy or motion tracking in general. Thus, the entertainment device may be implemented into a computer, a computer network or a computer system or may comprise a computer, a computer network or a computer system which runs one or more gaming software programs.

The entertainment device comprises at least one human-machine interface according to the present invention, such as according to one or more of the embodiments disclosed above and/or according to one or more of the embodiments disclosed below. The entertainment device is designed to enable at least one item of information to be input by a player by means of the human-machine interface. The at least one item of information may be transmitted to and/or may be used by a controller and/or a computer of the entertainment device.

In a further aspect of the present invention, a tracking system for tracking the position of at least one movable object is provided. As used herein, a tracking system is a device which is adapted to gather information on a series of past positions of the at least one object or at least one part of an object. Additionally, the tracking system may be adapted to provide information on at least one predicted future position of the at least one object or the at least one part of the object. The tracking system may have at least one track controller, which may fully or partially be embodied as an electronic device, preferably as at least one data processing device, more preferably as at least one computer or microcontroller. Again, the at least one track controller may comprise the at least one evaluation device and/or may be part of the at least one evaluation device and/or might fully or partially be identical to the at least one evaluation device.

The tracking system comprises at least one detector according to the present invention, such as at least one detector as disclosed in one or more of the embodiments listed above and/or as disclosed in one or more of the embodiments below. The tracking system further comprises at least one track controller. The tracking system may comprise one, two or more detectors, particularly two or more identical detectors, which allow for a reliable acquisition of depth information about the at least one object in an overlapping volume between the two or more detectors. The track controller is adapted to track a series of positions of the object, each position comprising at least one item of information on a position of the object at a specific point in time.

The tracking system may further comprise at least one beacon device connectable to the object. For a potential definition of the beacon device, reference may be made to WO 2014/097181 A1.

The tracking system preferably is adapted such that the detector may generate an information on the position of the object of the at least one beacon device, in particular to generate the information on the position of the object which comprises a specific beacon device exhibiting a specific spectral sensitivity. Thus, more than one beacon exhibiting a different spectral sensitivity may be tracked by the detector of the present invention, preferably in a simultaneous manner. Herein, the beacon device may fully or partially be embodied as an active beacon device and/or as a passive beacon device. As an example, the beacon device may comprise at least one illumination source adapted to generate at least one light beam to be transmitted to the detector. Additionally or alternatively, the beacon device may comprise at least one reflector adapted to reflect light generated by an illumination source, thereby generating a reflected light beam to be transmitted to the detector.

In a further aspect of the present invention, a scanning system for determining at least one position of at least one object is provided. As used herein, the scanning system is a device which is adapted to emit at least one light beam being configured for an illumination of at least one dot located at at least one surface of the at least one object and for generating at least one item of information about the distance between the at least one dot and the scanning system. For the purpose of generating the at least one item of information about the distance between the at least one dot and the scanning system, the scanning system comprises at least one of the detectors according to the present invention, such as at least one of the detectors as disclosed in one or more of the embodiments listed above and/or as disclosed in one or more of the embodiments below.

Thus, the scanning system comprises at least one illumination source which is adapted to emit the at least one light beam being configured for the illumination of the at least one dot located at the at least one surface of the at least one object. As used herein, the term "dot" refers to a small area on a part of the surface of the object which may be selected, for example by a user of the scanning system, to be illuminated by the illumination source. Preferably, the dot may exhibit a size which may, on one hand, be as small as possible in order to allow the scanning system determining a value for the distance between the illumination source comprised by the scanning system and the part of the surface of the object on which the dot may be located as exactly as possible and which, on the other hand, may be as large as possible in order to allow the user of the scanning system or the scanning system itself, in particular by an automatic procedure, to detect a presence of the dot on the related part of the surface of the object.

For this purpose, the illumination source may comprise an artificial illumination source, in particular at least one laser source and/or at least one incandescent lamp and/or at least one semiconductor light source, for example, at least one light-emitting diode, in particular an organic and/or inorganic light-emitting diode. On account of their generally defined beam profiles and other properties of handleability, the use of at least one laser source as the illumination source is particularly preferred. Herein, the use of a single laser source may be preferred, in particular in a case in which it may be important to provide a compact scanning system that might be easily storable and transportable by the user. The illumination source may thus, preferably be a constituent part of the detector and may, therefore, in particular be integrated into the detector, such as into the housing of the detector. In a preferred embodiment, particularly the housing of the scanning system may comprise at least one display configured for providing distance-related information to the user, such as in an easy-to-read manner. In a further preferred embodiment, particularly the housing of the scanning system may, in addition, comprise at least one button which may be configured for operating at least one function related to the scanning system, such as for setting one or more operation modes. In a further preferred embodiment, particularly the housing of the scanning system may, in addition, comprise at least one fastening unit which may be configured for fastening the scanning system to a further surface, such as a rubber foot, a base plate or a wall holder, such comprising as magnetic material, in particular for increasing the accuracy of the distance measurement and/or the handleablity of the scanning system by the user.

In a particularly preferred embodiment, the illumination source of the scanning system may, thus, emit a single laser beam which may be configured for the illumination of a single dot located at the surface of the object. By using at least one of the detectors according to the present invention at least one item of information about the distance between the at least one dot and the scanning system may, thus, be generated. Hereby, preferably, the distance between the illumination system as comprised by the scanning system and the single dot as generated by the illumination source may be determined, such as by employing the evaluation device as comprised by the at least one detector. However, the scanning system may, further, comprise an additional evaluation system which may, particularly, be adapted for this purpose. Alternatively or in addition, a size of the scanning system, in particular of the housing of the scanning system, may be taken into account and, thus, the distance between a specific point on the housing of the scanning system, such as a front edge or a back edge of the housing, and the single dot may, alternatively, be determined.

Alternatively, the illumination source of the scanning system may emit two individual laser beams which may be configured for providing a respective angle, such as a right angle, between the directions of an emission of the beams, whereby two respective dots located at the surface of the same object or at two different surfaces at two separate objects may be illuminated. However, other values for the respective angle between the two individual laser beams may also be feasible. This feature may, in particular, be employed for indirect measuring functions, such as for deriving an indirect distance which may not be directly accessible, such as due to a presence of one or more obstacles between the scanning system and the dot or which may otherwise be hard to reach. By way of example, it may, thus, be feasible to determine a value for a height of an object by measuring two individual distances and deriving the height by using the Pythagoras formula. In particular for being able to keep a predefined level with respect to the object, the scanning system may, further, comprise at least one leveling unit, in particular an integrated bubble vial, which may be used for keeping the predefined level by the user.

As a further alternative, the illumination source of the scanning system may emit a plurality of individual laser beams, such as an array of laser beams which may exhibit a respective pitch, in particular a regular pitch, with respect to each other and which may be arranged in a manner in order to generate an array of dots located on the at least one surface of the at least one object. For this purpose, specially adapted optical elements, such as beam-splitting devices and mirrors, may be provided which may allow a generation of the described array of the laser beams.

Thus, the scanning system may provide a static arrangement of the one or more dots placed on the one or more surfaces of the one or more objects. Alternatively, illumination source of the scanning system, in particular the one or more laser beams, such as the above described array of the laser beams, may be configured for providing one or more light beams which may exhibit a varying intensity over time and/or which may be subject to an alternating direction of emission in a passage of time. Thus, the illumination source may be configured for scanning a part of the at least one surface of the at least one object as an image by using one or more light beams with alternating features as generated by the at least one illumination source of the scanning device. In particular, the scanning system may, thus, use at least one row scan and/or line scan, such as to scan the one or more surfaces of the one or more objects sequentially or simultaneously.

In a further aspect of the present invention, a camera for imaging at least one object is disclosed. The camera comprises at least one detector according to the present invention, such as disclosed in one or more of the embodiments given above or given in further detail below. Thus, the detector may be part of a photographic device, specifically of a digital camera. Specifically, the detector may be used for 3D photography, specifically for digital 3D photography. Thus, the detector may form a digital 3D camera or may be part of a digital 3D camera. As used herein, the term "photography" generally refers to the technology of acquiring image information of at least one object. As further used herein, a "camera" generally is a device adapted for performing photography. As further used herein, the term "digital photography" generally refers to the technology of acquiring image information of at least one object by using a plurality of light-sensitive elements adapted to generate electrical signals indicating an intensity of illumination, preferably digital electrical signals. As further used herein, the term "3D photography" generally refers to the technology of acquiring image information of at least one object in three spatial dimensions. Accordingly, a 3D camera is a device adapted for performing 3D photography. The camera generally may be adapted for acquiring a single image, such as a single 3D image, or may be adapted for acquiring a plurality of images, such as a sequence of images. Thus, the camera may also be a video camera adapted for video applications, such as for acquiring digital video sequences.

Thus, generally, the present invention further refers to a camera, specifically a digital camera, more specifically a 3D camera or digital 3D camera, for imaging at least one object. As outlined above, the term imaging, as used herein, generally refers to acquiring image information of at least one object. The camera comprises at least one detector according to the present invention. The camera, as outlined above, may be adapted for acquiring a single image or for acquiring a plurality of images, such as image sequence, preferably for acquiring digital video sequences. Thus, as an example, the camera may be or may comprise a video camera. In the latter case, the camera preferably comprises a data memory for storing the image sequence.

In a further aspect of the present invention, a method for determining a position of at least one object is disclosed. The method preferably may make use of at least one detector according to the present invention, such as of at least one detector according to one or more of the embodiments disclosed above or disclosed in further detail below. Thus, for optional embodiments of the method, reference might be made to the description of the various embodiments of the detector. The method comprises the following steps, which may, preferably, be performed in the given or, at least partially, simultaneously. Further, the method steps might be repeated once or several times.

The method according to the present invention comprises the following steps:
- generating at least one sensor signal by using at least one optical sensor, wherein the optical sensor has at least one sensor region, wherein the at least one sensor signal is generated in a manner dependent on an illumination of the sensor region, wherein the sensor signal, given the same total power of the illumination, is dependent on a geometry of the illumination, in particular on a beam cross section of the illumination on the sensor region, wherein the sensor region has a photosensitive layer comprising a layer of a semiconducting material and having individual contacts to a first electrode and to a second electrode, wherein the first electrode is designed for collecting a first type of charge carriers and wherein the second electrode is designed for collecting a second type of the charge carriers, wherein the first type of the charge carriers and the second type of the charge carriers are generated in the photosensitive layer by the illumination, and wherein the first type of the charge carriers and the second type of the charge carriers are extractable from the photosensitive layer with different extraction rates; and
- evaluating the sensor signal by using at least one evaluation device designed to generate at least one item of information on a longitudinal position of the object.

For further details concerning the method according to the present invention, reference may be made to the description of the optical detector as provided above and/or below.

A further aspect of the present invention relates to a use of the optical detector as described elsewhere. Thus, generally, the optical detector may be applied in various fields of uses. Specifically, the detector may be applied for a purpose of use, selected from the group consisting of: a position measurement in traffic technology; an entertainment application; a human-machine interface application; a tracking application; a photography application; a cartography application; a mapping application for generating maps of at least one space; a homing or tracking beacon detector for vehicles; a mobile application; a webcam; an audio device; a Dolby surround audio system; a computer peripheral device; a gaming application; a camera or video application; a surveillance application; an automotive application; a transport application; a logistics application; a vehicle application; an airplane application; a ship application; a spacecraft application; a robotic application; a medical application; a sports' application; a building application; a construction application; a manufacturing application; a machine vision application; a use in combination with at least one sensing technology selected from time-of-flight detector, radar, Lidar, ultrasonic sensors, or interferometry. Additionally or alternatively, applications in local and/or global positioning systems may be named, especially landmark-based positioning and/or navigation, specifically for use in cars or other vehicles (such as trains, motorcycles, bicycles, trucks for cargo transportation), robots or for use by pedestrians. Further, indoor positioning systems may be named as potential applications, such as for household applications and/or for robots used in manufacturing, logistics, surveillance, or maintenance technology.

For further possible uses of the optical detector, reference may be made to any one of WO 2014/097181 A1, WO 2014/198626 A1, WO 2014/198629 A1, WO 2014/198625 A1, WO 2015/024871 A1, WO 2016/120392 A1, WO 2016/169871 A1, WO 2017/012964 A1, WO 2017/025567 A1, WO 2017/046121 A1, WO 2017/089540 A1, WO 2017/089553 A1, WO 2017/093453 A1, the full content of all of which is herewith also included by reference.

The above-described detector, the method, the human-machine interface and the entertainment device and also the proposed uses have considerable advantages over the prior art. Thus, generally, a simple and, still, efficient detector for an accurate determining a position of at least one object in space may be provided. In contrast to the observations as illustrated in WO 2012/110924 A1 and WO 2014/097181 A1, also crystalline silicon and crystalline germanium can now be used within the photosensitive layer, hereby providing the FiP effect, thus, overcoming the limitations as described in these state-of-the-art documents. As compared to other FiP devices, such as FiP devices which apply dye-sensitized solar cells (DSC) or photoconductors, larger ac photocurrents may be obtained in the optical sensor according to the present invention at comparative illumination levels, thus, allowing larger sensor signals. In addition, the advantages of the crystalline silicon and the crystalline germanium, specifically, their wide availability, their low-noise behavior and their high responsivity even in the NIR spectral range, can now made available also for FiP devices. The same can be true for the ratio of the in-focus response vs. the out-of-focus response while the frequency response (band width) may also, particularly, be increased.

Summarizing, in the context of the present invention, the following embodiments are regarded as particularly preferred:
Embodiment 1: A detector for an optical detection of at least one object, comprising:
   - at least one optical sensor, wherein the optical sensor has at least one sensor region, wherein the optical sensor is designed to generate at least one sensor signal in a manner dependent on an illumination of the sensor region, wherein the sensor signal, given the same total power of the illumination, is dependent on a geometry of the illumination, in particular on a beam cross section of the illumination on the sensor region, wherein the sensor region has a photosensitive layer comprising a layer of a semiconducting material and having individual contacts to a first electrode and to a second electrode, wherein the first electrode is designed for collecting a first type of charge carriers and wherein the second electrode is designed for collecting a second type of the charge carriers, wherein the first type of the charge carriers and the second type of the charge carriers are generated in the photosensitive layer by the illumination, and wherein the first type of the charge carriers and the second type of the charge carriers are extractable from the photosensitive layer with different extraction rates; and
   - at least one evaluation device, wherein the evaluation device is designed to generate at least one item of information on a longitudinal position of the object by evaluating the sensor signal.
Embodiment 2: The detector according to the preceding embodiment, wherein the first extraction rate and the second extraction rate differ from each other during an initial phase upon illuminating the sensor region of the optical sensor.
Embodiment 3: The detector according to the preceding embodiment, wherein the semiconducting material is selected from at least one of crystalline silicon, crystalline germanium, a crystalline silicon-germanium alloy; amorphous silicon, copper indium selenide (CIS), copper indium gallium diselenide (CIGS), copper zinc tin sulfide (CZTS), copper zinc tin selenide (CZTSe); a II-VI semiconductor, specifically cadmium telluride (CdTe) or nanoparticulate lead sulfide (np-PbS); a III-V semiconductor, specifically indium phosphide (InP), gallium arsenide (GaAs), or indium gallium arsenide (InGaAs); an organic semiconductor, a blend of at least two organic semiconductors, a blend of at least one organic semiconductor with inorganic semiconductive particles; a solid solution, a doped variant or a mixture thereof.
Embodiment 4: The detector according to any one of the preceding embodiments, wherein the first electrode and the second electrode are located on a single side of the photosensitive layer or wherein the photosensitive layer is embedded between the first electrode and the second electrode in a manner that the light beam is capable of arriving at the photosensitive layer.
Embodiment 5: The detector according to any one of the preceding embodiments, wherein the first type of charge carriers are electrons and the second type of charge carriers are holes, or wherein the first type of charge carriers are holes and the second type of charge carriers are electrons.
Embodiment 6: The detector according to any one of the preceding embodiments, wherein at least one extraction layer is arranged between the photosensitive layer and at least one of the first electrode or the second electrode.
Embodiment 7: The detector according to the preceding embodiment, wherein the extraction layer is designed for extracting the corresponding type of charge carriers from the photosensitive layer.
Embodiment 8: The detector according to any one of the two preceding embodiments, wherein a single extraction layer is arranged between the photosensitive layer and one of the first electrode and the second electrode.
Embodiment 9: The detector according to the preceding embodiment, wherein the photosensitive layer is separated from an adjacent electrode by at least one barrier, wherein the adjacent electrode is the other of the first electrode and the second electrode between which no extraction layer is arranged.
Embodiment 10: The detector according to the preceding embodiment, wherein the barrier separates the photosensitive layer from the adjacent electrode.
Embodiment 11: The detector according to any one of the two preceding embodiments, wherein the barrier is designed to limit the extraction rate for the type of the charge carriers for which the adjacent electrode is designed for collecting.
Embodiment 12: The detector according to any one of the three preceding embodiments, wherein the barrier comprises a Schottky barrier generated at a boundary of the photosensitive layer and the adjacent electrode.
Embodiment 13: The detector according to any one of the four preceding embodiments, wherein the barrier comprises an individual blocking layer.
Embodiment 14: The detector according to the preceding embodiment, wherein the blocking layer is arranged between the photosensitive layer and the other of the adjacent electrode.
Embodiment 15: The detector according to any one of the two preceding embodiments, wherein the blocking layer is designed to block the corresponding type of the charge carriers by having a lower electrical conductivity for one of the two types of the charge carriers with respect to the photosensitive layer, wherein the low electrically conductivity of the blocking layer is below the electrical conductivity of the semiconducting material within the photosensitive layer and above 10⁻⁶ S/cm, preferably above 10⁻⁵ S/cm, more preferred above 10⁻⁴ S/cm.
Embodiment 16: The detector according to any one of the three preceding embodiments, wherein the blocking layer comprises a layer of one or more of silicon dioxide (SiO₂), titanium dioxide (TiO₂), zinc oxide (ZnO), aluminum oxide (Al₂O₃), zirconium dioxide (ZrO₂), molybdenum oxide (MoO₃), silicon nitride (Si₃N₄), or a polymer film.
Embodiment 17: The detector according to any one of embodiments 6 or 7, wherein a first extraction layer is arranged between the photosensitive layer and the first electrode and wherein a second extraction layer is arranged between the photosensitive layer and the second electrode.
Embodiment 18: The detector according to the preceding embodiment, wherein the first extraction layer is designed for extracting the first type of charge carriers from the photosensitive layer with a first extraction rate, wherein the second extraction layer is designed for extracting the second type of charge carriers from the photosensitive layer with a second extraction rate.
Embodiment 19: The detector according to any one of the thirteen preceding embodiments, wherein the photosensitive layer comprises a layer of crystalline silicon, wherein the extraction layer, depending on the type of charge carriers for which the extraction layer is designed for extracting, comprises a layer of n-type or of p-type amorphous silicon.
Embodiment 20: The detector according to the preceding embodiment, wherein the first extraction layer is designed for extracting holes and comprises a layer of p-type amorphous silicon and wherein the second extraction layer is designed for extracting electrons and comprises a layer of n-type amorphous silicon, or wherein the first extraction layer is designed for extracting electrons and comprises a layer of n-type amorphous silicon and wherein the second extraction layer is designed for extracting holes and comprises a layer of p-type amorphous silicon
Embodiment 21: The detector according to any one of the fifteen preceding embodiments, wherein a passivation layer is additionally arranged between the photosensitive layer and the extraction layer.
Embodiment 22: The detector according to the preceding embodiment, wherein the photosensitive layer comprises a layer of crystalline silicon, wherein the passivation layer comprises a layer of i-type amorphous silicon.
Embodiment 23: The detector according to any one of the two preceding embodiments, wherein the passivation layer is designated for reducing a process of charge recombination of opposing types of charge carriers, specifically, at a surface of the photosensitive layer, wherein then process of charge recombination competes with a process of charge extraction.
Embodiment 24: The detector according to any one of the eighteen preceding embodiments, wherein the semiconducting material in the photosensitive layer is selected to adjust a relative height of charge transport levels in the photosensitive layer and the adjacent extraction layer.
Embodiment 25: The detector according to the preceding embodiment, wherein the photosensitive layer comprises a blend of copper zinc tin sulfide (CZTS) and copper zinc tin selenide (CZTSe), wherein a ratio of sulfur (S) to selenium (Se) is selected to adjust the relative height of the charge transport levels in the photosensitive layer and the adjacent extraction layer.
Embodiment 26: The detector according to any one of the two preceding embodiments, wherein the photosensitive layer comprises at least one organic compound being selected to adjust the relative height of the charge transport levels in the photosensitive layer and the adjacent extraction layer.
Embodiment 27: The detector according to any one of the preceding embodiments, wherein at least one of the first electrode and the second electrode is optically intransparent and/or reflective and comprises a metal electrode.
Embodiment 28: The detector according to the preceding embodiment, wherein the metal electrode comprises one or more of a silver, platinum, gold, aluminum, titanium, chromium, or molybdenum, or an alloy thereof.
Embodiment 29: The detector according to any one of the two preceding embodiments, wherein the metal electrode comprises a thin layer of deposited metal, wherein the thin layer has a thickness of 10 nm to 1000 nm, preferably of 50 nm to 500 nm, in particular of 100 nm to 250 nm.
Embodiment 30: The detector according to any one of the preceding embodiments, wherein a first collection layer is arranged adjacent to the first electrode between the first electrode and the photosensitive layer and/or wherein a second collection layer is arranged adjacent to the second electrode between the second electrode and the photosensitive layer.
Embodiment 31: The detector according to the preceding embodiment, wherein at least one of the first collection layer and the second collection layer is a transparent conducting layer.
Embodiment 32: The detector according to the preceding embodiment, wherein the transparent conducting layer is or comprises a layer of a transparent conducting oxide (TCO).
Embodiment 33: The detector according to the preceding embodiment, wherein the transparent conducting oxide (TCO) is selected from at least one of indium-doped tin oxide (ITO), fluorine-doped tin oxide (FTO), and aluminum-doped zinc oxide (AZO).
Embodiment 34: The detector according to any one of the preceding embodiments, wherein the optical sensor comprises a split electrode.
Embodiment 35: The detector according to the preceding embodiment, wherein the split electrode comprises at least two partial electrodes.
Embodiment 36: The detector according to any of the two preceding embodiments, wherein the split electrode adjoins the conducting layer.
Embodiment 37: The detector according to any of the preceding embodiments, wherein the sensor region of the longitudinal optical sensor is exactly one continuous sensor region, wherein the longitudinal sensor signal is a uniform sensor signal for the entire sensor region.
Embodiment 38: The detector according to any of the preceding embodiments, wherein the optical sensor is adapted to generate the sensor signal by one or more of measuring an electrical resistance or a conductivity of at least one part of the sensor region.
Embodiment 39: The detector according to the preceding embodiment, wherein the optical sensor is adapted to generate the sensor signal by performing at least one current-voltage measurement and/or at least one voltage-current-measurement.
Embodiment 40: The detector according to any of the preceding embodiments, wherein the detector furthermore has at least one modulation device for modulating the illumination.
Embodiment 41: The detector according to the preceding embodiment, wherein the detector is designed to detect at least two sensor signals in the case of different modulations, in particular at least two sensor signals at respectively different modulation frequencies, wherein the evaluation device is designed to generate the at least one item of information on the position of the object by evaluating the at least two sensor signals.
Embodiment 42: The detector according to any one of the preceding embodiments, furthermore comprising at least one illumination source.
Embodiment 43: The detector according to the preceding embodiment, wherein the illumination source is selected from: an illumination source, which is at least partly connected to the object and/or is at least partly identical to the object; an illumination source which is designed to at least partly illuminate the object with a primary radiation.
Embodiment 44: The detector according to the preceding embodiment, wherein the light beam is generated by a reflection of the primary radiation on the object and/or by light emission by the object itself, stimulated by the primary radiation.
Embodiment 45: The detector according to any one of the three preceding embodiments, wherein the spectral sensitivities of the optical sensor is covered by the spectral range of the illumination source.
Embodiment 46: The detector according to any of the preceding embodiments, wherein the detector has at least two optical sensors, wherein the optical sensors are stacked.
Embodiment 47: The detector according to the preceding embodiment, wherein the optical sensors are stacked along an optical axis of the detector.
Embodiment 48: The detector according to any one of the preceding embodiments, wherein the detector further comprises at least one imaging device.
Embodiment 49: The detector according to the preceding claim, wherein the imaging device is located in a position furthest away from the object.
Embodiment 50: The detector according to any of the two preceding embodiments, wherein the light beam passes through the at least one optical sensor before illuminating the imaging device.
Embodiment 51: The detector according to any of the three preceding embodiments, wherein the imaging device comprises a camera.
Embodiment 52: The detector according to any of the four preceding embodiments, wherein the imaging device comprises at least one of: an inorganic camera; a monochrome camera; a multichrome camera; a full-color camera; a pixelated inorganic chip; a pixelated organic camera; a CCD chip, preferably a multi-color CCD chip or a full-color CCD chip; a CMOS chip; an IR camera; an RGB camera.
Embodiment 53: A human-machine interface for exchanging at least one item of information between a user and a machine, in particular for inputting control commands, wherein the human-machine interface comprises at least one detector according to any of the preceding embodiments relating to a detector, wherein the human-machine interface is designed to generate at least one item of geometrical information of the user by means of the detector wherein the human-machine interface is designed to assign to the geometrical information at least one item of information, in particular at least one control command.
Embodiment 54: The human-machine interface according to the preceding embodiment, wherein the at least one item of geometrical information of the user is selected from the group consisting of: a position of a body of the user; a position of at least one body part of the user; an orientation of a body of the user; an orientation of at least one body part of the user.
Embodiment 55: The human-machine interface according to any of the two preceding embodiments, wherein the human-machine interface further comprises at least one beacon device connectable to the user, wherein the human-machine interface is adapted such that the detector may generate an information on the position of the at least one beacon device.
Embodiment 56: The human-machine interface according to the preceding embodiment, wherein the beacon device comprises at least one illumination source adapted to generate at least one light beam to be transmitted to the detector.
Embodiment 57: An entertainment device for carrying out at least one entertainment function, in particular a game, wherein the entertainment device comprises at least one human-machine interface according to any of the preceding embodiments referring to a human-machine interface, wherein the entertainment device is designed to enable at least one item of information to be input by a player by means of the human-machine interface, wherein the entertainment device is designed to vary the entertainment function in accordance with the information.
Embodiment 58: A tracking system for tracking the position of at least one movable object, the tracking system comprising at least one detector according to any of the preceding embodiments referring to a detector, the tracking system further comprising at least one track controller, wherein the track controller is adapted to track a series of positions of the object, each comprising at least one item of information on a position of the object at a specific point in time.
Embodiment 59: The tracking system according to the preceding embodiment, wherein the tracking system further comprises at least one beacon device connectable to the object, wherein the tracking system is adapted such that the detector may generate an information on the position of the object of the at least one beacon device.
Embodiment 60: A scanning system for determining at least one position of at least one object, the scanning system comprising at least one detector according to any of the preceding embodiments relating to a detector, the scanning system further comprising at least one illumination source adapted to emit at least one light beam configured for an illumination of at least one dot located at at least one surface of the at least one object, wherein the scanning system is designed to generate at least one item of information about the distance between the at least one dot and the scanning system by using the at least one detector.
Embodiment 61: The scanning system according to the preceding embodiment, wherein the illumination source comprises at least one artificial illumination source, in particular at least one laser source and/or at least one incandescent lamp and/or at least one semiconductor light source.
Embodiment 62: The scanning system according to any one of the two preceding embodiments, wherein the illumination source emits a plurality of individual light beams, in particular an array of light beams exhibiting a respective pitch, in particular a regular pitch.
Embodiment 63: The scanning system according to any one of the three preceding embodiments, wherein the scanning system comprises at least one housing.
Embodiment 64: The scanning system according to the preceding embodiment, wherein the at least one item of information about the distance between the at least one dot and the scanning system distance is determined between the at least one dot and a specific point on the housing of the scanning system, in particular a front edge or a back edge of the housing.
Embodiment 65: The scanning system according to any one of the two preceding embodiments, wherein the housing comprises at least one of a display, a button, a fastening unit, a leveling unit.
Embodiment 66: A camera for imaging at least one object, the camera comprising at least one detector according to any one of the preceding embodiments referring to a detector.
Embodiment 67: A method for an optical detection of at least one object, in particular using a detector according to any of the preceding embodiments relating to a detector, comprising the following steps:
   - generating at least one sensor signal by using at least one optical sensor, wherein the optical sensor has at least one sensor region, wherein the at least one sensor signal is generated in a manner dependent on an illumination of the sensor region, wherein the sensor signal, given the same total power of the illumination, is dependent on a geometry of the illumination, in particular on a beam cross section of the illumination on the sensor region, wherein the sensor region has a photosensitive layer comprising a layer of a semiconducting material and having individual contacts to a first electrode and to a second electrode, wherein the first electrode is designed for collecting a first type of charge carriers and wherein the second electrode is designed for collecting a second type of the charge carriers, wherein the first type of the charge carriers and the second type of the charge carriers are generated in the photosensitive layer by the illumination, and wherein the first type of the charge carriers and the second type of the charge carriers are extractable from the photosensitive layer with different extraction rates; and
   - evaluating the sensor signal by using at least one evaluation device designed to generate at least one item of information on a longitudinal position of the object.
Embodiment 68: A use of a detector according to the previous embodiment, for a purpose of use, selected from the group consisting of: a distance measurement, in particular in traffic technology; a position measurement, in particular in traffic technology; an entertainment application; a security application; a human-machine interface application; a scanning application, a tracking application; a logistics application; a machine vision application; a safety application; a surveillance application; a data collection application; a photography application; an imaging application or camera application; a mapping application for generating maps of at least one space.

### Brief description of the figures

Further optional details and features of the invention are evident from the description of preferred exemplary embodiments which follows in conjunction with the dependent claims. In this context, the particular features may be implemented alone or with features in combination. The invention is not restricted to the exemplary embodiments. The exemplary embodiments are shown schematically in the figures. Identical reference numerals in the individual figures refer to identical elements or elements with identical function, or elements which correspond to one another with regard to their functions.

Specifically, in the figures:
- Figure 1: illustrates a preferred exemplary embodiment of a detector for optical detection of at least one object according to the present invention in a schematic fashion, wherein the detector comprises at least one longitudinal optical sensor having a sensor region comprising at least one photosensitive layer;
- Figures 2A and 2B: each illustrate a cross-sectional area of a particularly preferred exemplary setup of the longitudinal optical sensor in a schematic fashion;
- Figures 3A and 3B: each illustrate a cross-sectional area of a further particularly preferred exemplary setup of the longitudinal optical sensor in a schematic fashion;
- Figures 4A and 4B: each illustrate a cross-sectional area of a further particularly preferred exemplary setup of the longitudinal optical sensor in a schematic fashion; and
- Figure 5: shows an exemplary embodiment of the optical detector and of a detector system, a human-machine interface, an entertainment device, a tracking system, and a camera in a schematic fashion, each comprising the optical detector according to the present invention.

### Exemplary embodiments

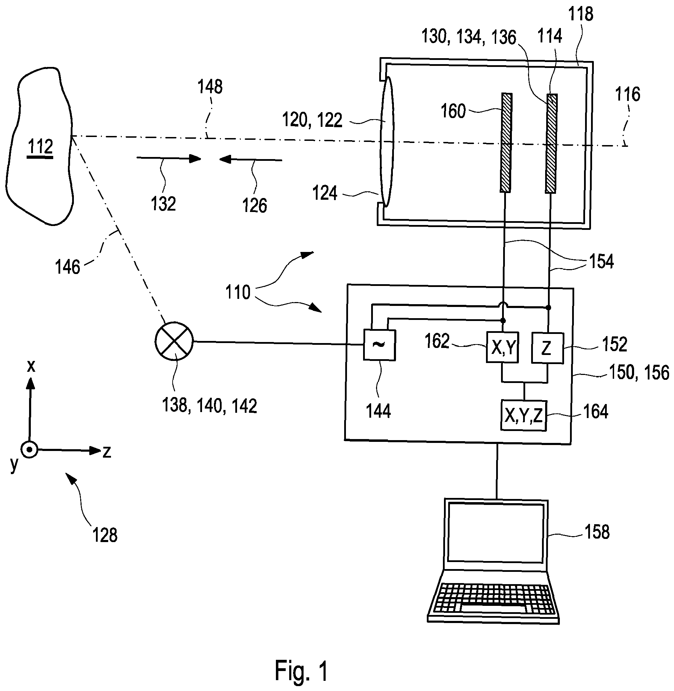

Figure 1 illustrates, in a highly schematic illustration, a first exemplary embodiment of a detector 110 according to the present invention for determining a position of at least one object 112. However, other embodiments are feasible. In general, the Figures and the various elements as displayed therein are not to scale.

The detector 110 as schematically depicted in Figure 1 comprises at least one optical sensor 114, which, in this particular embodiment, is arranged along an optical axis 116 of the detector 110. Specifically, the optical axis 116 may be an axis of symmetry and/or rotation of the setup of the optical sensors 114. The optical sensors 114 may be located inside a housing 118 of the detector 110. Further, at least one transfer device 120 may be comprised, preferably a refractive lens 122. An opening 124 in the housing 118, which may, particularly, be located concentrically with regard to the optical axis 116, preferably, defines a direction of view 126 of the detector 110. A coordinate system 128 may be defined, in which a direction parallel or antiparallel to the optical axis 116 is defined as a longitudinal direction, whereas directions perpendicular to the optical axis 116 may be defined as transversal directions. In the coordinate system 128, symbolically depicted in Figure 1, a longitudinal direction is denoted by "z" while transversal directions are denoted by "x" and "y", respectively. However, other types of coordinate systems 128 may also be feasible.

Further, the optical sensor 114 is designed to generate at least one longitudinal sensor signal in a manner dependent on an illumination of a sensor region 130 comprised by the longitudinal optical sensor 114 by an incident light beam 132. Thus, according to the FiP effect, the sensor signal, given the same total power of the illumination, is dependent on a beam cross-section of the light beam 132 in the respective sensor region 130. According to the present invention, the sensor region 130 of the optical sensor 114 has at least photosensitive layer 134 comprising a layer of a semiconducting material, preferably a crystalline semiconducting material, specifically, a layer 136 of crystalline silicon, also abbreviated to "c-Si", and/or a layer of at least one of crystalline germanium, a crystalline silicon-germanium alloy, or a doped variant thereof. However, other kinds of semiconducting materials which may, in particular, be selected from amorphous silicon, copper indium selenide (CIS), copper indium gallium diselenide (CIGS), copper zinc tin sulfide (CZTS), copper zinc tin selenide (CZTSe); a II-VI semiconductor, specifically cadmium telluride (CdTe) or nanoparticulate lead sulfide (np-PbS); a III-V semiconductor, specifically indium phosphide (InP), gallium arsenide (GaAs), or indium gallium arsenide (InGaAs); an organic semiconductor, a blend of at least two organic semiconductors, a blend of at least one organic semiconductor with inorganic semiconductive particles; a solid solution, a doped variant or a mixture thereof.

The light beam 132 for illumining the sensor region 130 of the longitudinal optical sensor 114 may be generated by a light-emitting object 112 being capable of providing the illumination. Alternatively or in addition, the light beam 132 may be generated by a separate illumination source 138, which may include an ambient light source and/or an artificial light source, such as a light-emitting diode (LED) 140, which may be adapted to illuminate the object 112 in a fashion that the object 112 may be able to reflect at least a part of the light generated by the illumination source 138 in a manner that the light beam 132 may reach the sensor region 130 of the longitudinal optical sensor 114, preferably by entering the housing 118 of the optical detector 110 through the opening 124 along the optical axis 116.

In general, the illumination source 138 may be capable of providing a constant light beam at least over a predefined time interval designated for illuminating the sensor region 130. However, in the particular embodiment as schematically depicted in Figure 1, the illumination source 138 is a modulated light source 142, wherein one or more modulation properties of the illumination source may be controlled by at least one modulation device 144. Alternatively or in addition, the modulation may be effected in a first beam path 146 between the illumination source and the object 112 and/or in a second beam path 148 between the object 112 and the longitudinal optical sensor 114. Further possibilities may be conceivable. In this particular embodiment, it may be advantageous to take into account one or more of the modulation properties, in particular the modulation frequency, when evaluating the sensor signal of the optical sensor 114 for determining the at least one item of information on the position of the object 112 in an evaluation device 150.

The evaluation device 150 is, generally, designed to generate at least one item of information on a position of the object 112 by evaluating the sensor signal of the longitudinal optical sensor 114. Herein, the evaluation device 150 may comprise one or more electronic devices and/or one or more software components, in order to evaluate the sensor signals, which are symbolically denoted by a longitudinal evaluation unit 152 (denoted by "z"). For this purpose, the evaluation device 150 may, preferably, be adapted to determine the at least one item of information on the longitudinal position of the object 112 by comparing more than one sensor signals of the optical sensor 114. As explained above, the longitudinal sensor signal as provided by the longitudinal optical sensor 114 upon impingement by the light beam 132 depends on an illumination of the sensor region 130 by the light beam 132, wherein the longitudinal sensor signal, given the same total power of the illumination, is dependent on a beam cross-section of the light beam 132 in the sensor region 130 and, if applicable, on a modulation frequency of the light beam 132. As for example explained in WO 2012/110924 A1 in more detail, the evaluation device 150 may, thus, be adapted to determine the at least one item of information on the longitudinal position of the object 112 by comparing more than one longitudinal sensor signals of the longitudinal optical sensor 114.

Generally, the evaluation device 150 may be part of a data processing device and/or may comprise one or more data processing devices. The evaluation device 150 may be fully or partially integrated into the housing 118 and/or may fully or partially be embodied as a separate device which is electrically connected in a wireless or wire-bound fashion, such as via one or more signal leads 154, to the longitudinal optical sensor 114. The evaluation device 150 may further comprise one or more additional components, such as one or more electronic hardware components and/or one or more software components, such as one or more measurement units and/or one or more evaluation units (not depicted in Figure 1) and/or one or more controlling units, such as the modulation device 144 being adapted to control the modulation properties of the modulated light source 142. Further, the evaluation device 150 may be a computer 156 and/or may comprise a computer system comprising a data processing device 158. However, other embodiments may also be feasible.

In the particular embodiment as depicted in Figure 1, the optical detector 110 further comprises at least one transversal optical sensor 160 which, in this particular embodiment, is also arranged along an optical axis 116 of the detector 110. Herein, the transversal optical sensor 160 may, preferably, be adapted to determine a transversal position of the modulated light beam 132 traveling from the object 112 to the optical detector 110. Herein, the transversal position may be a position in at least one dimension perpendicular an optical axis 116 of the optical detector 110, in this particular embodiment denoted by "x" and "y", respectively, according to the coordinate system 128. The transversal optical sensor 160 as used here may comprise a known position sensitive device (PSD), in particular a photodetector as, for example, disclosed in WO 2012/110924 A1 or WO 2014/097181 A1, or a photoconductor as, for example, disclosed in WO 2016/120392 A1. However, other setups of the transversal optical sensor 160 may also be applicable here.

For the purpose of determining the transversal position, the transversal optical sensor 160 may further be adapted to generate at least one transversal sensor signal. The transversal sensor signal may be transmitted in a wireless or wire-bound fashion, such as via one or more signal leads 154, to the evaluation device 150, which may further be designed to generate at least one item of information on a transversal position of the object 112 by evaluating the transversal sensor signal. For this purpose, the evaluation device 150 may further comprise one or more electronic devices and/or one or more software components, in order to evaluate the sensor signals, which are symbolically denoted by a transversal evaluation unit 162 (denoted by "z"). Further, by combining results derived by the evolution units 152, 162, position information 164, preferably three-dimensional position information, symbolically denoted here by "x, y, z", may thus be generated.

The optical detector 110 may have a straight beam path or a tilted beam path, an angulated beam path, a branched beam path, a deflected or split beam path or other types of beam paths. Further, the light beam 132 may propagate along each beam path or partial beam path once or repeatedly, unidirectionally or bidirectionally. Thereby, the components listed above or the optional further components listed in further detail below may fully or partially be located in front of the longitudinal optical sensors 114 and/or behind the longitudinal optical sensors 114.

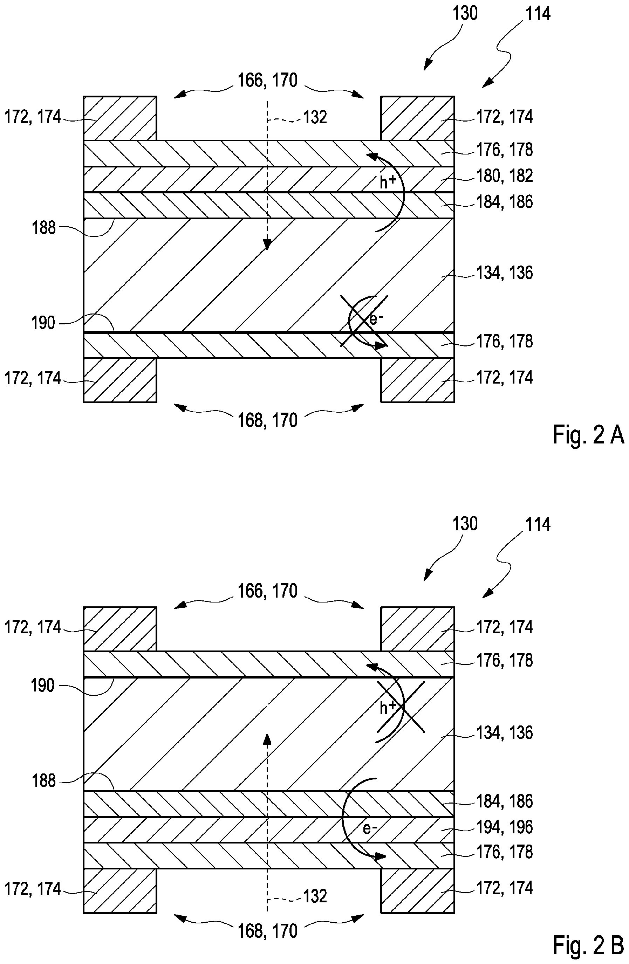

Figures 2A, 2B, 3A, 3B, 4A, and 4B each illustrate a cross-sectional area of an exemplary setup of a particularly preferred example of the sensor region 130 of the optical sensor 114 according to the present invention in a highly schematic fashion. As already indicated above, the at least one photosensitive layer 134 as comprised by the sensor region 130 has at least one material which is susceptible to an influence of the incident light beam 132. As described elsewhere in this document, upon illumination of the photosensitive layer 134 by the incident light beam 132, an amount of charge carriers is generated within the photosensitive layer 134, wherein the amount of the charge carriers which are generated in this fashion exhibits a dependency on both a power and a cross-section of the illumination of the photosensitive layer 134, thus, resulting in a the sensor signal which exhibits the same dependency.

As further illustrated in Figures 2A, 2B, 3A, 3B, 4A, and 4B, the sensor region 130 of the optical sensor 114 comprises at least one first electrode 166 and at least one second electrode 168 which are arranged in a manner that the photosensitive layer 134 is embedded between the first electrode 166 and the second electrode 168. As an alternative, an arrangement in which both the first electrode 166 and the second electrode 168 may be arranged as back contacts with regard to a direction of the incident light beam 132 on a single side of the photosensitive layer 134 may also be advantageous. Independent of the actual arrangement of the electrodes 166, 168, the first electrode 166 is designed for collecting a first type of charge carriers whereas the second electrode 168 is designed for collecting a second type of charge carriers. As already mentioned above, both types of the charge carriers are generated within the photosensitive layer 134 by the illumination of the incident light beam 132 and may, subsequently, be collected by one of the first electrode 166 or the second electrode 168. As particularly depicted in Figures 2A, 2B, 3A, 3B, 4A, and 4B, the first types of charge carriers is considered here as holes while the second type of charge carriers is considered here as electrons. However, alternative examples (not depicted here) are conceivable, wherein the first types of charge carriers may be considered as electrons while the second type of charge carriers may be considered as holes.

In this particular embodiment, at least one of the first electrode 166 and the second electrode 168 may be split electrodes 170 comprising at least one partial electrode 172. Preferably, each of the partial electrodes 172 may be a metal electrode 174 which may, preferably, comprise one or more of silver, platinum, gold, aluminum, titanium, chromium, or molybdenum, or an alloy thereof. However, further electrode materials may also be feasible. In particular, in order to increase the mechanical stability of the optically intransparent electrode and, concurrently, using as little electrode material as possible, the metal electrode 174 may comprise a thin metal layer deposited onto a substrate. Preferably, the thin metal layer may exhibit a thickness of 10 nm to 1000 nm, preferably of 50 nm to 500 nm, in particular of 100 nm to 250 nm.

As further indicated in Figures 2A, 2B, 3A, 3B, 4A, and 4B, at least one collection layer 176 may be used as the corresponding substrate. In particular, for a purpose of improving an electronic contact of both the first electrode 166 and the second electrode 168 to the photosensitive layer 134 and/or a further layer which may, additionally, be located between the photosensitive layer 134 and one of the first electrode 166 or the second electrode 168 as well for facilitating the light beam 132 to impinge the photosensitive layer 134 in order to generate the desired charge carriers, the collection layer 176 being located within the path of the incident light beam 132 may, thus, at least partially be optically transparent. Preferably, the collection layer 176 may comprise a layer 178 of at least one transparent conductive oxide (TCO), in particular having at least one of indium-doped tin oxide (ITO), fluorine-doped tin oxide (FTO), or aluminum-doped zinc oxide (AZO). However, other kinds of optically transparent materials, such optically transparent electrically conducting organic compounds may also be applicable.

According to the present invention, the layer of the semiconducting material as comprised by the photosensitive layer 134 may, specifically, be the layer 136 of crystalline silicon (C-Si) and/or a layer selected from at least one of crystalline germanium, a crystalline silicon-germanium alloy, or a doped variant thereof. However, as already indicated above, experiment results as disclosed in WO 2012/110924 A1 and WO 2014/097181 A1 have shown that using crystalline silicon and germanium within the photosensitive layer may not be capable of providing the desired FiP effect. Thus, in order to overcome the limitations as described in these state-of-the-art documents, the different types of charge carriers, i.e. the holes h and the electrons e, are extractable from the photosensitive layer 134 with different extraction rates, wherein a sustaining difference between the first extraction rate for an extraction of the first type of the charge carriers from the photosensitive layer 134 and a second extraction rate for the extraction of the second type of the charge carriers from the photosensitive layer 134 can be observed. In order to achieve this result, Figures 2A, 2B, 3A, 3B, 4A, and 4B illustrate different exemplary arrangements of the sensor region 130 of the optical sensor 114 in all of which the first type of the charge carriers, i.e. the holes, and the second type of the charge carriers, i.e. the electrons, are extractable from the photosensitive layer 134 with a first extraction rate with regard to the holes and a second extraction rate concerning the electrons, wherein the first extraction rate and the second extraction rate differ with respect to each other. As a result, a symmetry of an extraction of the two types of charge carriers present in the photosensitive layer 134 can, thus, be broken, whereby a negative FiP effect can now also be obtained by using the detector 110 according to the present invention having the photosensitive layer 136 comprising the crystalline silicon, the crystalline germanium, the crystalline silicon-germanium alloy, or the doped variant thereof, resulting in the geometry dependence of the sensor signals on the illumination of the sensor region 130 as described elsewhere in this document.

In the exemplary embodiment as schematically illustrated in Figure 2A, a first extraction layer 180 is arranged between the photosensitive layer 134 and the first electrode 166, specifically as a single extraction layer. For a function of the collection layer 176 which is, additionally, located here between the first extraction layer 180 and the first electrode 166, reference may be made to the description of the collection layer 176 above. As already indicated above, the single first extraction layer 180 is designated here for extracting a particular type of charge carriers, i.e. holes h, which are collected by the first electrode 166 from the photosensitive layer 134. Consequently, a first extraction rate which is defined for the holes can be associated with the first extraction layer 180. Herein, the first extraction layer 180 may, preferably, be or comprise at least one semiconducting absorber layer which may, preferably, depend on the kind of the charge carriers, specifically, a layer 182 of p-doped amorphous silicon or "p:a-Si", in particular, in the exemplary embodiment as illustrated here in which the photosensitive layer 134 comprises the c-Si.

In addition, a passivation layer 184 may, preferably, be located as an additional layer between the photosensitive layer 134 and the adjacent extraction layer 180. Herein, the passivation layer comprises a further semiconductive layer which is designated for reducing a process of charge recombination of opposing types of charge carriers, i.e. electrons and holes. For the passivation layer 184, a thin layer 186 of intrinsic amorphous silicon or "i:a-Si" may be used, specifically intrinsic amorphous silicon that can itself be passivated by applying hydrogen, in particular, in a manner that a number of dangling bonds within the i:a-Si may be reduced by several orders of magnitude. As already described above in more detail, the process of charge recombination competes with the process of charge extraction. As a result of providing the passivation layer 184, whereby the process of charge recombination at an adjacent surface 188 of the photosensitive layer 134 may be reduced, the charge extraction from the photosensitive layer 134 and, thus, the first extraction rate concerning the holes may be increased in this fashion.

In particular, in order to reduce the second extraction rate which is associated with the rate of the extraction of the electrons from the photosensitive layer 134, the photosensitive layer is separated from the second electrode 168 which is designed here for collecting the electrons e from the photosensitive layer 134 by a barrier 190. Thus, the barrier 190 is arranged in a manner that it separates the photosensitive layer 134 from the adjacent second electrode 168. Consequently, no extraction layer is arranged between the photosensitive layer 134 and the adjacent second electrode 168, whereby the second extraction rate defined as the rate of the extraction of the electrons from the photosensitive layer 134 is significantly reduced. As a result, the first extraction rate associated with the extraction of the holes h from the photosensitive layer 134 considerably exceeds the second extraction rate associated with the extraction of the electrons e from the photosensitive layer 134. For the function of the collection layer 176 which is, in addition, located here between the photosensitive layer 134 and the second electrode 168, reference may, again, be made to the description of the collection layer 176 above.

As already indicated above, the barrier 190 is designated in order to generate a repulsive electrical potential for the electrons for which the adjacent second electrode 168 is designed for collecting. In the exemplary embodiment of Figure 2A, the barrier 190 may comprise a Schottky barrier (not depicted here), which may, alternatively, be denoted as a "Schottky contact", which may be generated by the photosensitive layer 134 and the metal provided by the adjacent second electrode 168. As a result of an interaction between the semiconducting photosensitive layer 134 and the metallic material as provided by the adjacent second electrode 168, the Schottky barrier may, thus, spontaneously be formed. Therefore, in order to allow the light beam to, still, arrive at the photosensitive layer 134, the barrier 190 can, preferably, be arranged in a manner that it may be located away from a direction where the light beam 132 is designated to enter the optical sensor 114.

In contrast to Figure 2A, the exemplary embodiment as depicted in Figure 2B the optical sensor 114 comprises a second extraction layer 194 which is arranged between the photosensitive layer 134 and the second electrode 168, specifically, again, as the single extraction layer. As already indicate above, the single second extraction layer 194 is designated here for extracting a different type of charge carriers, i.e. electrons e, which are collected by the second electrode 168 from the photosensitive layer 134 with the second extraction associated with the electrons. Herein, the second extraction layer 194 may, again, be or comprise at least one semiconducting absorber layer, preferably, depending on the kind of the charge carriers, i.e. the electrons, specifically, a layer 196 of n-doped amorphous silicon or "n:a-Si", in particular, in the exemplary embodiment as illustrated here in which the photosensitive layer 134 comprises the c-Si.

In further contrast to Figure 2A, separating the photosensitive layer from the first electrode 166 designated for collecting the holes h from the photosensitive layer 134 by the barrier 190, which may, again, be or comprise the Schottky barrier (not depicted here) as already presented above, in the exemplary embodiment as depicted in Figure 2B can considerably reduce the first extraction rate associated with the rate of the extraction of the holes from the photosensitive layer 134. Consequently, no extraction layer is arranged here between the photosensitive layer 134 and the adjacent first electrode 166, whereby the first extraction rate defined as the rate of the extraction of the holes from the photosensitive layer 134 is significantly reduced. As a result, the second extraction rate associated with the extraction of the electrons *e* from the photosensitive layer 134 considerably exceeds the first extraction rate associated with the extraction of the holes h from the photosensitive layer 134. For the functioning of the collection layer 176 and the passivation layer 184, which are, additionally, comprised by the exemplary embodiment as shown in Figure 2B, reference may be made to the description above.

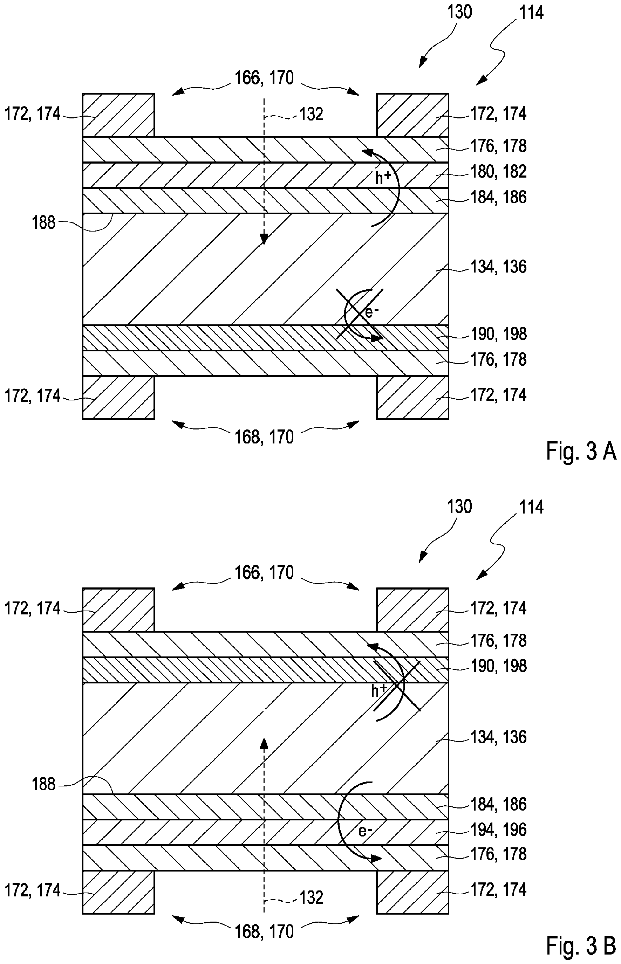

In contrast to Figure 2A, the barrier 190 in the exemplary embodiment of the optical sensor 114 as depicted in Figure 3A is provided in form of a separate, individual blocking layer 198. As indicated above, the blocking layer 198 is or comprises a low electrical conductivity layer having an electrical conductivity below the electrical conductivity of the semiconducting material within the photosensitive layer 134 but still above 10⁻⁶ S/cm, preferably above 10⁻⁵ S/cm, more preferred above 10⁻⁴ S/cm, wherein the blocking layer 198 is designed for impeding a transport of at least one type of charge carriers, specifically, by being adapted to influence a path of permeating electrically conducting particles, in particular of the electrons or the holes. By locating the blocking layer 198 into the optical sensor 114, a height of the barrier and hence a performance of the optical sensor 114 can be adjusted. Herein, the blocking layer 198 may, in particular, comprise a thin film of an electrically conducting material, in particular one or more of silicon dioxide (SiO₂), titanium dioxide (TiO₂), zinc oxide (ZnO), aluminum oxide (Al₂O₃), zirconium dioxide (ZrO₂), or molybdenum oxide (MoO₃). For this purpose, further kinds of materials, specifically a nitride, such as silicon nitride (Si₃N₄) or a polymer film, may, however, also be feasible. Herein, the blocking layer 198 may exhibit optically at least partially transparent properties, thus, allowing the incident light beam 132 to enter the optical sensor 114 also from an opposing side compared to the exemplary embodiment of Figure 2A.

Similarly, the barrier 190 in the exemplary embodiment of the optical sensor 114 as depicted in Figure 3B is, in contrast to Figure 2B, also arranged in form of the separate, individual blocking layer 198. For further details, reference may be made to the description of Figure 3A.

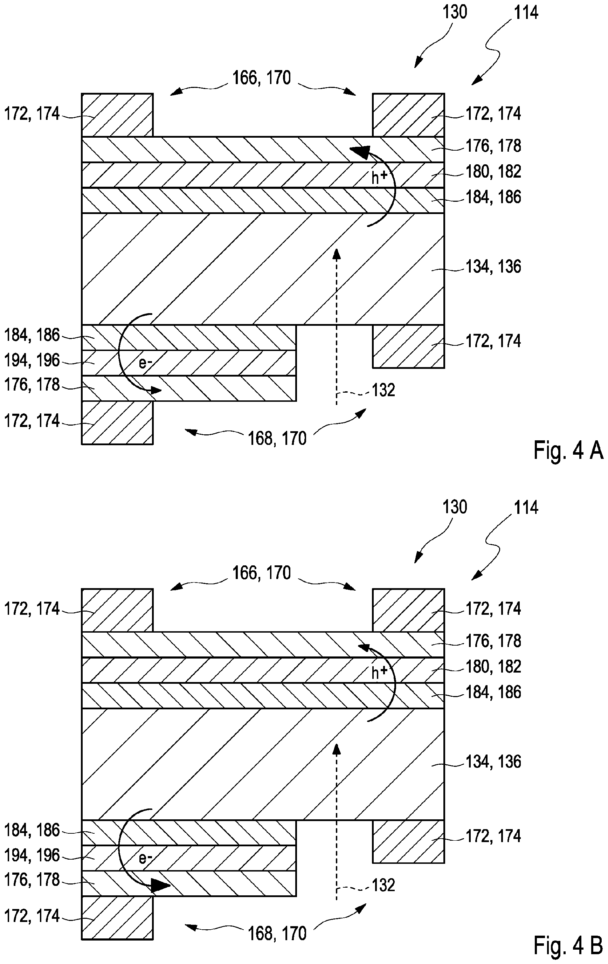

The exemplary embodiment as depicted in Figure 4A comprises, similar to Figure 2A, the first extraction layer 180 and a corresponding passivation layer 184 which are both arranged between the photosensitive layer 134 and the first electrode 166 but, in contrast to Figure 2A, instead of the barrier 190 also the second extraction layer 194 and the corresponding passivation layer 184 which are both arranged between the photosensitive layer 134 and the second electrode 168. Herein, the first extraction layer 180 is designated for extracting the holes h from the photosensitive layer 134 with a large first extraction rate, wherein the second extraction layer 194 is designated for extracting the electrons *e* from the photosensitive layer 134 with a low second extraction rate, such that the large first extraction rate for the holes h exceeds the low second extraction rate for the electrons e, whereby the FiP effect may, thus, be observable by the optical detector 110.

The exemplary embodiment as shown in Figure 4B comprises a similar setup to the embodiment as depicted in Figure 4A, wherein, in contrast to Figure 4A, the large second extraction rate for the electrons e exceeds the low first extraction rate for the holes h, specifically, by similar figures as indicated above, whereby the FiP effect may, thus, again be observable by the optical detector 110.

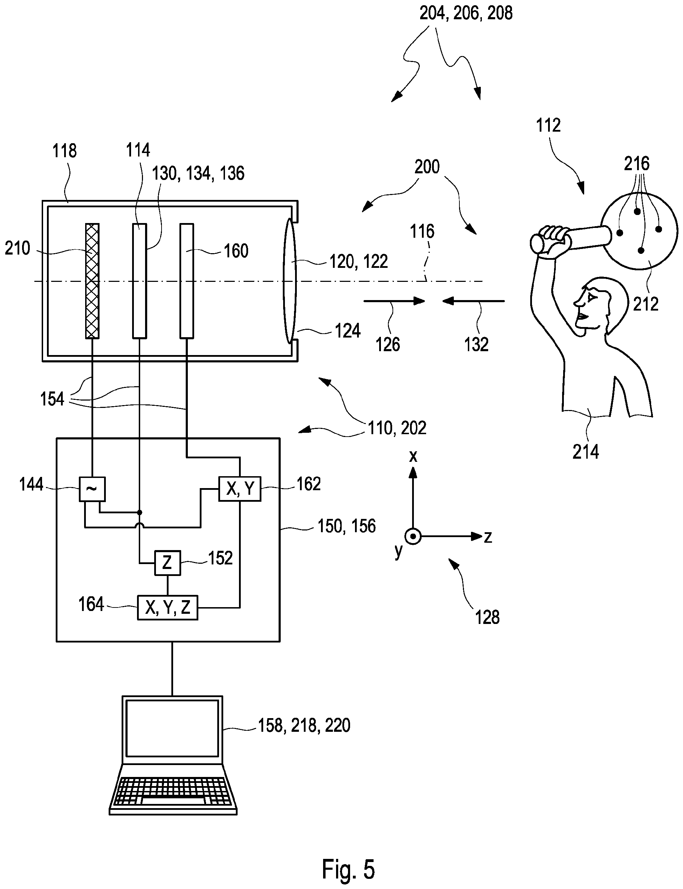

Figure 5 shows an exemplary embodiment of a detector system 200, comprising at least one optical detector 110, such as the optical detector 110 comprising the photosensitive layer 134 as disclosed in one or more of the embodiments shown in Figures 2A, 2B, 3A, 3B, 4A or 4B or a combination thereof. Herein, the optical detector 110 may be employed as a camera 202, specifically for 3D imaging, which may be made for acquiring images and/or image sequences, such as digital video clips. Further, Figure 5 shows an exemplary embodiment of a human-machine interface 204, which comprises the at least one detector 110 and/or the at least one detector system 200, and, further, an exemplary embodiment of an entertainment device 206 comprising the human-machine interface 204. Figure 5 further shows an embodiment of a tracking system 208 adapted for tracking a position of at least one object 112, which comprises the detector 110 and/or the detector system 200.

With regard to the optical detector 110 and to the detector system 200, reference may be made to the full disclosure of this application. Basically, all potential embodiments of the detector 110 may also be embodied in the embodiment shown in Figure 5. As described above, the one or more optical sensors 114 are used in order to provide the longitudinal sensor signals, wherein the evaluation device may be connected to each one of the optical sensors 114, in particular, by the signal leads 154. The evaluation device 150 may further be connected to the at least one optional transversal optical sensor 160, in particular, by the signal leads 154. By way of example, the signal leads 154 may be provided and/or one or more interfaces, which may be wireless interfaces and/or wire-bound interfaces. Further, the signal leads 154 may comprise one or more drivers and/or one or more measurement devices for generating sensor signals and/or for modifying sensor signals. Further, again, the at least one transfer device 120 may be provided, in particular as the refractive lens 122 or convex mirror. The optical detector 110 may further comprise the at least one housing 118 which, as an example, may encase one or more of components.

Further, the evaluation device 150 may fully or partially be integrated into the at least one optical sensor 114 and/or into other components of the optical detector 110. The evaluation device 150 may also be enclosed into the housing 118 and/or into a separate housing. The evaluation device 150 may comprise one or more electronic devices and/or one or more software components, in order to evaluate the sensor signals, which are symbolically denoted by the longitudinal evaluation unit 152 (denoted by "z") and a transversal evaluation unit 162 (denoted by "x y"). By combining results derived by these evolution units, a position information 164, preferably a three-dimensional position information, may be generated (denoted by "x y z").

The at least one optional transversal optical sensor 160 may, preferably, be provided in a setup using a known PSD, in particular a photodetector as disclosed e.g. in WO 2012/110924 A1 or WO 2014/097181 A1 or a photoconductor as disclosed e.g. in WO 2016/120392 A1. However, other setups of the transversal optical sensor 160 may also be feasible. In case an intransparent transversal optical sensor 160 may be used, the optical sensor 114 may be placed in a manner that it is impinged first by the incident light beam 132.

Further, the optical detector 110 and/or to the detector system 200 may comprise an imaging device 210 which may be configured in various ways. Thus, as depicted in Figure 5, the imaging device 210 can be part of the detector 110 within the detector housing 118. Herein, the imaging device signal may be transmitted by one or more signal leads 154 to the evaluation device 150 of the detector 110. Alternatively, the imaging device 210 may be separately located outside the detector housing 118. The imaging device 210 may be fully or partially transparent or intransparent. The imaging device 210 may be or may comprise an organic imaging device or an inorganic imaging device. Preferably, the imaging device 210 may comprise at least one matrix of pixels, wherein the matrix of pixels may particularly be selected from the group consisting of: an inorganic semiconductor sensor device such as a CCD chip and/or a CMOS chip; an organic semiconductor sensor device.

In the exemplary embodiment as shown in Figure 5, the object 112 to be detected, as an example, may be designed as an article of sports equipment and/or may form a control element 212, the position and/or orientation of which may be manipulated by a user 214. Thus, generally, in the embodiment shown in Figure 5 or in any other embodiment of the detector system 200, the human-machine interface 204, the entertainment device 206 or the tracking system 208, the object 112 itself may be part of the named devices and, specifically, may comprise the at least one control element 212, specifically, wherein the at least one control element 212 has one or more beacon devices 216, wherein a position and/or orientation of the control element 212 preferably may be manipulated by user 214. As an example, the object 112 may be or may comprise one or more of a bat, a racket, a club or any other article of sports equipment and/or fake sports equipment. Other types of objects 112 are possible. Further, the user 214 may be considered as the object 112, the position of which shall be detected. As an example, the user 214 may carry one or more of the beacon devices 216 attached directly or indirectly to his or her body.

The optical detector 110 may be adapted to determine at least one item on a longitudinal position of one or more of the beacon devices 216 and, optionally, at least one item of information regarding a transversal position thereof, and/or at least one other item of information regarding the longitudinal position of the object 112 and, optionally, at least one item of information regarding a transversal position of the object 112. Particularly, the optical detector 110 may be adapted for identifying colors and/or for imaging the object 112, such as different colors of the object 112, more particularly, the color of the beacon devices 216 which might comprise different colors. The opening 124 in the housing 118, which, preferably, may be located concentrically with regard to the optical axis 116 of the detector 110, may preferably define the direction of a view 126 of the optical detector 110.

The optical detector 110 may be adapted for determining the position of the at least one object 112. Additionally, the optical detector 110, specifically an embodiment including the camera 202, may be adapted for acquiring at least one image of the object 112, preferably a 3D-image. As outlined above, the determination of a position of the object 112 and/or a part thereof by using the optical detector 110 and/or the detector system 200 may be used for providing a human-machine interface 204, in order to provide at least one item of information to a machine 218. In the embodiments as schematically depicted in Figure 5, the machine 218 may be or may comprise at least one computer and/or a computer system comprising the data processing device 158. Other embodiments are feasible. The evaluation device 150 may be a computer 156 and/or may comprise a computer 156 and/or may fully or partially be embodied as a separate data processing device 158 and/or may fully or partially be integrated into the machine 218, particularly the computer. The same holds true for a track controller 220 of the tracking system 208, which may fully or partially form a part of the evaluation device 150 and/or the machine 218.

Similarly, as outlined above, the human-machine interface 204 may form part of the entertainment device 206. Thus, by means of the user 214 functioning as the object 112 and/or by means of the user 214 handling the object 112 and/or the control element 212 functioning as the object 112, the user 214 may input at least one item of information, such as at least one control command, into the machine 218, particularly the separate data processing device 158, thereby varying the entertainment function, such as controlling the course of a computer game.

### List of reference numbers

- 110: detector
- 112: object
- 114: optical sensor
- 116: optical axis
- 118: housing
- 120: transfer device
- 122: refractive lens
- 124: opening
- 126: direction of view
- 128: coordinate system
- 130: sensor region
- 132: light beam
- 134: photosensitive layer
- 136: layer of crystalline silicon (c-Si)
- 138: illumination source
- 140: light-emitting diode
- 142: modulated illumination source
- 144: modulation device
- 146: first beam path
- 148: second beam path
- 150: evaluation device
- 152: longitudinal evaluation unit
- 154: signal leads
- 156: computer
- 158: data processing device
- 160: transversal optical sensor
- 162: transversal evaluation unit
- 164: position information
- 166: first electrode
- 168: second electrode
- 170: split electrode
- 172: partial electrode
- 174: metal electrode
- 176: collection layer
- 178: layer of transparent conductive oxide (TCO)
- 180: first extraction layer
- 182: layer of p-doped amorphous silicon (p:-a-Si)
- 184: passivation layer
- 186: layer of intrinsic amorphous silicon (i:-a-Si)
- 188: adjacent surface of photosensitive layer
- 190: barrier
- 194: second extraction layer
- 196: layer of n-doped amorphous silicon (n:-a-Si)
- 198: blocking layer
- 200: detector system
- 202: camera
- 204: human-machine interface
- 206: entertainment device
- 208: tracking system
- 210: imaging device
- 212: control element
- 214: user
- 216: beacon device
- 218: machine
- 220: track controller

## Claims

1. A detector (110) for optically detecting at least one object (112), comprising
- at least one optical sensor (114), wherein the optical sensor (114) has at least one sensor region (130), wherein the optical sensor (114) is designed to generate at least one sensor signal in a manner dependent on an illumination of the sensor region (130), wherein the sensor signal, given the same total power of the illumination, is dependent on a geometry of the illumination, wherein the sensor region (130) has a photosensitive layer (134) comprising a layer (136) of a semiconducting material and having individual contacts to a first electrode (166) and to a second electrode (168), wherein the first electrode (166) is designed for collecting a first type of charge carriers and wherein the second electrode (168) is designed for collecting a second type of the charge carriers, wherein the first type of the charge carriers and the second type of the charge carriers are generated in the photosensitive layer (134) by the illumination, and wherein the first type of the charge carriers and the second type of the charge carriers are extractable from the photosensitive layer (134) with different extraction rates; and
- at least one evaluation device (150), wherein the evaluation device (150) is designed to generate at least one item of information on a longitudinal position of the object (112) by evaluating the sensor signal.

2. The detector (110) according to the preceding claim, wherein the semiconducting material is selected from at least one of crystalline silicon, crystalline germanium, a crystalline silicon-germanium alloy, amorphous silicon, copper indium selenide (CIS), copper indium gallium diselenide (CIGS), copper zinc tin sulfide (CZTS), copper zinc tin selenide (CZTSe), a II-VI semiconductor, a III-V semiconductor, an organic semiconductor, a blend of at least two organic semiconductors, a blend of at least one organic semiconductor with inorganic semiconductive particles, a solid solution, a doped variant or a mixture thereof.

3. The detector (110) according to any one of the preceding claims, wherein at least one extraction layer (180,194) is arranged between the photosensitive layer (134) and at least one of the first electrode (166) or the second electrode (168), wherein the extraction layer (180,194) is designed for extracting a corresponding type of charge carriers from the photosensitive layer (134).

4. The detector (110) according to any one of the preceding claims, wherein a single extraction layer (180, 194) is arranged between the photosensitive layer (134) and one of the first electrode (166) or the second electrode (168), whereas the photosensitive layer (134) is separated from an adjacent electrode being the other of the first electrode (166) or the second electrode (168) by at least one barrier (190), wherein the barrier (190) is designed to limit the extraction rate for the type of the charge carriers for which the adjacent electrode is designed for collecting.

5. The detector (110) according to the preceding claim, wherein the barrier (190) is arranged in a manner that it separates the photosensitive layer (134) from the adjacent electrode.

6. The detector (110) according to any one of the two preceding claims, wherein the barrier (190) comprises a Schottky barrier generated at a boundary of the photosensitive layer (134) and the adjacent electrode.

7. The detector (110) according to any one of the three preceding claims, wherein the barrier (190) comprises an individual blocking layer (198), wherein the blocking layer (198) is designed to block the corresponding type of the charge carriers, wherein the blocking layer (198) is arranged between the photosensitive layer (134) and the adjacent electrode.

8. The detector (110) according to the preceding claim, wherein the blocking layer (198) comprises a layer of one or more of silicon dioxide (SiO₂), titanium dioxide (TiO₂), zinc oxide (ZnO), aluminum oxide (Al₂O₃), zirconium dioxide (ZrO₂), molybdenum oxide (MoO₃), silicon nitride (Si₃N₄), or a polymer film.

9. The detector (110) according to claim 3, wherein a first extraction layer (180) is arranged between the photosensitive layer (134) and the first electrode (166) and wherein a second extraction layer (194) is arranged between the photosensitive layer (134) and the second electrode (168), wherein the first extraction layer (180) is designed for extracting the first type of charge carriers from the photosensitive layer (134) with the first extraction rate, wherein the second extraction layer (194) is designed for extracting the second type of charge carriers from the photosensitive layer (134) with the second extraction rate.

10. The detector (110) according to any one of the seven preceding claims, wherein a passivation layer (184) is additionally arranged between the photosensitive layer (134) and the extraction layer (180, 194).

11. The detector (110) according to any one of the nine preceding claims, wherein the photosensitive layer (134) comprises a layer (136) of crystalline silicon, wherein the extraction layer (180, 194), depending on the type of charge carriers for which the extraction layer is designed for extracting, comprises a layer (182, 196) of n-type amorphous silicon or of p-type amorphous silicon.

12. The detector (110) according to the preceding claim, wherein the photosensitive layer (134) comprises a layer (136) of crystalline silicon, wherein the passivation layer (184) comprises a layer of i-type amorphous silicon.

13. The detector (110) according to any one of the preceding claims, wherein a collection layer (176) is arranged adjacent to one of the first electrode (166) or the second electrode (168) between the adjacent electrode and the photosensitive layer (134).

14. A method for an optical detection of at least one object (112), the method comprising:
- generating at least one sensor signal by using at least one optical sensor (114), wherein the optical sensor (114) has at least one sensor region (130), wherein the optical sensor (114) is designed to generate at least one sensor signal in a manner dependent on an illumination of the sensor region (130), wherein the sensor signal, given the same total power of the illumination, is dependent on a geometry of the illumination, wherein the sensor region (130) has a photosensitive layer (134) comprising a layer (136) of a semiconducting material and having individual contacts to a first electrode (166) and to a second electrode (168), wherein the first electrode (166) is designed for collecting a first type of charge carriers and wherein the second electrode (168) is designed for collecting a second type of the charge carriers, wherein the first type of the charge carriers and the second type of the charge carriers are generated in the photosensitive layer (134) by the illumination, and wherein the first type of the charge carriers and the second type of the charge carriers are extractable from the photosensitive layer (134) with different extraction rates; and
- evaluating the sensor signal by using at least one evaluation device (150) designed to generate at least one item of information on a longitudinal position of the object (112).

15. A use of a detector (110) according to any one of the preceding claims referring to a detector (110), for a purpose of use, selected from the group consisting of: a distance measurement, in particular in traffic technology; a position measurement, in particular in traffic technology; an entertainment application; a security application; a human-machine interface application; a tracking application; a logistics application; a machine vision application; a safety application; a surveillance application; a data collection application; a scanning application, a photography application; an imaging application or camera application; a mapping application for generating maps of at least one space.
